# EUROPEAN PATENT APPLICATION

(11) **EP 4 827 001 A1**
(43) Date of publication of application: **21.10.2026**
(21) Application number: 25305553.7
(22) Date of filing: 15.04.2025
(51) Int. Cl.: H03M 13/29, H03M 13/39, H03M 13/11, H03M 13/23, H03M 13/41, H03M 13/00

(54) **METHOD OF DECODING RECURSIVE CONVOLUTIONAL CODES, AND CORRESPONDING DECODER AND COMPUTER PROGRAM PRODUCT**

(71) Applicant: Institut Mines Telecom, 91120 Palaiseau (FR)
(72) Inventor: ABDEL NOUR, Chabrel, 91120 PALAISEAU (FR); NADAL, Jérémy, 91120 PALAISEAU (FR); JABOUR, Joseph, 91120 PALAISEAU (FR); DOUILLARD, Catherine, 91120 PALAISEAU (FR); WEITHOFFER, Stefan, 91120 PALAISEAU (FR)
(74) Representative: Vidon Brevets & Stratégie

(57) **Abstract**

Method for decoding received codewords c generated by a transmission encoder using a recursive convolutional code with puncturing, said codewords c comprising a set of *K* source symbols and a set of *M* parity symbols, wherein said method decodes said received codewords using a syndrome former matrix ***S*** with *K + M* rows and *N_{seq}*⊥ columns, *M-1 ≤ N_{seq}*⊥ *≤ M,* or a corresponding transposed syndrome former matrix ***S***^{†}, said syndrome former matrix columns being composed of a set of *N_{seq}*⊥ constrained dual codewords obtained from a predetermined dual encoder of said transmission encoder, each constrained dual codeword comprising a set of *M* dual source symbols and a set of *K* dual parity symbols, organized so as said constrained dual codeword comprises a single non-zero sub-codeword, all other symbols of the dual codeword being zero symbols, the number of non-zero elements in said matrix being kept as low as possible, at least the last non-zero element in a given column being followed, on the line carrying said last non-zero element and in the next column, by a non-zero element, and wherein said decoding comprises a computation of *N_{seq}*⊥ syndrome symbols applied locally on the non-zero sub-codeword of each constrained dual codeword.

## Description

### Technical context

The field of the invention is error-correcting coding. Error-correcting coding is mainly used in the fields of telecommunications and computer/electronics, to detect and correct errors in data transmission and storage.

The invention relates to any application using a convolutional code or turbo code, whether standardized or proprietary, such as:
- Communications and broadcast networks: 4G, 5G based on the evolution of LTE pro, Wi-FI (IEEE 802.11a/b/g/n/ac/ax), DAB (Digital Audio Broadcasting), powerline transmission (PLC) HomePlugAV/AV2, DVBRCS/RCS2.
- Data storage: DVD, HDD and SSD hard disks.

Examples of high-speed applications in the communication field are:
- Virtual reality applications: telemedicine, education, video games, etc. A satisfactory immersive experience requires low latencies (a few tens of milliseconds) and very high data rates (10 Gb/s to 1 Tb/s depending on the type of compression used) to transmit a good-quality video stream.
- High-speed satellites (HTS): HTS will extend mobile network coverage worldwide. They will be able to carry the same data load as terrestrial mobile networks, offering several times the throughput of conventional fixed satellite services, at a lower cost.

### Prior art

Turbo codes are capacity-approaching error correction codes that are introduced in the 1990s. They have found widespread applications in modem communication systems such as long-term evolution (LTE). A turbo code consists of two (or more) constituent recursive systematic convolutional codes. They offer high flexibility for a large range of data block sizes and coding rates. The different coding rates are obtained by puncturing some transmitted data, allowing for rate compatibility.

Puncturing transmitted data is used to achieve higher coding rates and can be performed on any error-correction code. A high-rate turbo code can still maintain a good performance even after puncturing. However, unlike the low-density parity check (LDPC) codes which has higher throughput and lower complexity at higher coding rates, the high-rate turbo

codes still suffer from high complexity due to the fact that the decoding complexity relies on the base code rate (rate of the unpunctured constituent convolutional codes).

The decoding complexity of the turbo codes can be reduced by reducing the complexity of the constituent convolutional decoders. To do so, it is crucial to not only optimize the complexity of the constituent codes, but to find an alternative representation that allows decoding the constituent convolutional codes at a minimal complexity, which will then allow for attaining, a high-performance and low-complexity turbo codes.

Therefore, there is a need to drastically reduce the complexity and power consumption of error-correcting decoders (in a ratio greater than 10 compared with the state of the art) without any significant loss of correction performance.

### Features of the invention and associated advantages

The invention relates to a method for decoding received codewords c generated by a transmission encoder using a recursive convolutional code with puncturing, said codewords c comprising a set of *K* source symbols and a set of *M* parity symbols,
wherein said method decodes said received codewords using a syndrome former matrix ***S*** with *K + M* rows and *N*_{*seq*_{⊥}} columns, *M-1 ≤ N* _{*seq*_{⊥}} *≤ M,* or a corresponding transposed syndrome former matrix *S*^{†},
said syndrome former matrix columns being composed of a set of *N*_{*seq*_{⊥}} constrained dual codewords obtained from a predetermined dual encoder of said transmission encoder, said *N*_{*seq*_{⊥}} columns being linearly independent,
the columns and the rows being exchanged where the transposed syndrome former matrix *S*^{†} is used,
each constrained dual codeword comprising a set of *M* dual source symbols and a set of *K* dual parity symbols, organized so as said constrained dual codeword comprises a single non-zero sub-codeword, comprising a dual source symbol part, respectively a dual parity symbol part, starting with a first non-zero symbol and terminating with a last non-zero symbol, of length independent of *K,* all other symbols of the dual codeword being zero symbols, the number of non-zero elements in said matrix being kept as low as possible,
at least the last non-zero element in a given column being followed, on the line carrying said last non-zero element and in the next column, by a non-zero element,
and wherein said decoding comprises a computation of *N*_{*seq*_{⊥}} syndrome symbols, said computation being applied locally on the non-zero sub-codeword of each constrained dual codeword.

Thus, the invention provides an alternative decoding of a convolutional code, based on a dual code, and more precisely on a syndrome former matrix obtained from this dual code, so as to simplify its decoding process. The invention applies in particular to recursive systematic convolutional (RSC) codes, which are commonly used in code concatenations, such as turbo codes. It also applies to non-systematic convolutional codes, since it is known that it always exists an equivalent systematic convolutional code of a non-systematic convolutional codes.

By selecting an efficient dual encoder and limiting the computation locally to specific sub-codewords, it is possible to drastically reduce the decoding complexity, as it will be more clearly shown later.

As mentioned above, the invention implements a syndrome former matrix, or a corresponding transposed syndrome former matrix. The present specification and the claims describe the use of the syndrome former matrix. However, the person skilled in the art will directly deduce the implementation of the invention with a transposed matrix, by inverting the rows and columns.

According to a specific embodiment, the method of the invention comprises following steps for a conversion of said recursive convolutional code into a syndrome former:
- step 1: building said predetermined dual encoder of said transmission encoder, without considering said puncturing, by selecting, among several available dual encoders, the predetermined dual encoder fulfilling following conditions:
   - the predetermined dual encoder is directly derived from the encoding structure of the original transmission encoder;
   - the positions of the *K* dual source symbols *x*_{⊥} in the dual codewords *c*_{⊥} of the corresponding predetermined dual encoder are aligned with the positions of the *K* parity symbols *y* in the original codeword *c* of said transmission encoder before puncturing;
- step 2: identifying said set *N*_{*seq*_{⊥}} constrained dual sequences, under the form of a list of *N*_{*seq*_{⊥}} constrained return-to-state-zero, or RTZ, sequences under following constraints:
   - encoding said sequence with said predetermined dual encoder produces a dual codeword comprising a single non-zero sub-codeword;
   - symbols of said sequence at punctured positions of said puncturing are set to zero;
- step 3: encoding then puncturing dual source symbols of said *N*_{*seq*_{⊥}} constrained RTZ sequences using said predetermined dual encoder, providing *N*_{*seq*_{⊥}} constrained dual codewords, each comprising a set of *M* dual source symbols and a set of *K* dual parity symbols;
- step 4: combining said *N*_{*seq*_{⊥}} constrained dual codewords to form said syndrome former matrix ***S*** having *N*_{*seq*_{⊥}} columns, each column corresponding to one of said constrained dual codewords.

These steps enable to efficiently build a syndrome former based on a dual code corresponding to the recursive convolutional code with puncturing used by the transmission encoder, with much lower computational complexity than the state-of-art decoders, while keeping similar level of error-rate performance.

According to different embodiments, at least two approaches are conceivable for step 4. Thus, according to a first approach, a multi-binary (more generally a multi-symbol, the invention not being limited to binary coding) convolutional syndrome former is generated. In other words, said step 4 is a step of:
- step 4A: constructing a multi-symbol convolutional syndrome former structure based on a decomposition of said syndrome former matrix *S* into at most *M* sub-matrices, called linear transformation blocks, or LTBs, *Tⱼ*.

According to a second approach, said step 4 is a step of:
- step 4B: constructing a graph structure based on said syndrome former matrix ***S**.* Then, the method can comprise a step 5 of decoding said received codewords considering the syndrome former constructed in step 4.

Due to the syndrome former matrix, the decoding is particularly efficient.

It is notably possible to apply known decoding solutions, and said step 5 of decoding may use at least one of the decoding algorithms belonging to the group comprising:
- Message Passing Algorithm (MPA);
- Maximum A Posteriori Probability algorithm (MAP);
- Viterbi Algorithm (VA).

According to a specific embodiment, the dual source symbol part of the *n*^{th} constrained dual codeword starts at a position corresponding to the position of the *n*^{th} transmitted parity symbol in the transmission encoder.

This makes it possible to select a dual encoder well adapted to the implementation of the invention.

Notably, said *N*_{*seq*_{⊥}} constrained dual RTZ sequences, or said *N*_{*seq*_{⊥}} constrained dual RTZ codewords, can be selected using selection criteria aiming to find an equivalent syndrome former for said dual encoder suitable for low-complexity decoding.

The invention can notably apply to a transmission code having a coding rate *r*/(*r +* 1). The regular puncturing enables several aspects to be simplified, notably Step 2.

For example, Step 2 can comprise the steps of:
- identifying a first constrained dual RTZ sequence *x*₀^{⊥};
- obtaining the *N*_{*seq*_{⊥}} *-* 1 remaining constrained dual RTZ sequence with a right-hand rotation of x₀^{⊥} by ${x}_{n}^{⊥} = {↺}_{- nr} {x}_{0}^{⊥}$, multiples of *r:* $n ∈ \left〚0,{N}_{{seq}^{⊥}}-1\right〛$.

Rotation in the opposite direction (left-hand rotation) is also possible.

Further simplifications are available, when *r* is equal to the convolution period *p* of said predetermined dual encoder, the first constrained dual RTZ sequence being composed of only two non-zero symbols, separated in position by *p* - 1 symbols at 0.

According to a particular embodiment, Step 4A comprises the following step:
- decomposing said syndrome former matrix ***S*** in at most *M* linear transformation blocks *Tⱼ, j* ≤*M*, each linear transformation blocks *Tⱼ* being decomposed into two sub-blocks (*Xⱼ, Zⱼ*)*,* where *Xⱼ* and Z*ⱼ* matrices are sub-blocks extracted from matrix ***S**,*
   *Xⱼ* corresponding to an extraction performed on *hⱼ^{x}* successive rows among the first *K* rows in ***S*** and *ω* successive columns and *Zⱼ*, corresponding to an extraction is performed on *hⱼ^{z}* successive rows among the last *M* rows in ***S*** and *ω* successive columns,
   and all sub-blocks *Xⱼ* and Z*ⱼ* satisfy the following set of constraints:
- each row of the syndrome former matrix ***S*** must be assigned to exactly one sub-block;
- the linear transformation blocks contain all non-zero elements of the syndrome former matrix ***S*;**
- the starting column position of the *j*^{th} linear transformation block is circularly anterior to the starting column position of the (*j* + 1)^{th} linear transformation blocks.

Meeting these constraints results in an efficient decomposition of the syndrome former matrix.

In particular, the multi-symbol convolutional syndrome former can take as inputs, at each time instance *j,* inputs *hⱼ^{x}* source symbols *xⱼ* and *hⱼ^{z}* parity symbols *zⱼ* extracted from the transmitted codewords c and processes these inputs using the linear transformation blocks *Tⱼ*, providing an output *bⱼ:* ${b}_{j} = \left[{x}_{j}, {z}_{j}\right] \times {T}_{j}$ said output *bⱼ* updating the contents of a size-(*ω* - 1) register *qⱼ* = [*qⱼ*[0], ... , *qⱼ*[*ω* - 2]] so that, at each instance *j*, the multi-symbol convolutional syndrome former generates an output syndrome symbol *ηⱼ*, computed as ${η}_{j} = {b}_{j} \left[0\right] ⊕ {q}_{j} \left[0\right]$

According to a specific embodiment, in Step 2:
- *ω* -1 is equal to the positional distance between the first and the last non-zero symbols in the dual source symbol part in the first constrained dual codeword;
- *hⱼ^{z}* is equal to 1;
- *hⱼ^{x}* is equal to *r*;
- all the linear transform blocks *Tⱼ* have the same content *T.*

In this particular case, decoding is even less complex.

An example that is even more effective is the case where *r* is equal to the convolution period of the dual encoder *p* and *ω* is equal to 2.

According to another particular aspect, Step 4B can comprise constructing a general decoding graph structure, composed of nodes connected by edges, each node imposing constraints on every message entering that node, the decoding graph structure comprising:
- a source nodes sub-graph composed of *K g*-type nodes *gₓ*;
- a parity nodes sub-graph composed of *M g*-type nodes *g_{z}*;
- *N*_{*seq*_{⊥}} base graph sub-graphs, each base graph *n, n ∈* [0*, N*_{*seq*_{⊥}} -1]*,* being composed of two *f*-type nodes, named *f_{uₙ}* for the upper *f*-type node of the base graph and *f_{dₙ}* for the lower *f*-type node,
wherein a *f*-type node imposes a parity constraint on the messages of all edges connected to that node and a *g*-type node imposes an equality constraint on a message of all edges connected to that node,
and two interconnection networks based on said encoded constrained dual codewords provided by Step 3, interconnecting respectively said source nodes sub-graph with said *N*_{*seq*_{⊥}} base graph sub-graphs and said *N*_{*seq*_{⊥}} base graph sub-graphs with said parity nodes sub-graph.

This allows to construct the interconnection networks, based on the constrained dual codewords provided by step 3.

According to a particular embodiment, wherein the transmission encoder uses a concatenation of at least two recursive convolutional codes, each recursive convolutional code being previously turned into a multi-symbol convolutional syndrome former.

It is thus possible to decodes turbo-codes, consisting of multiple, e.g. two, constituent convolutional codes separated by interleavers.

In another aspect, the invention relates to a method for decoding received codewords *c,* said codewords c being generated by a transmission encoder composed of multiple recursive convolutional codes with different puncturing, each encoding the same *K* source symbols, wherein the method comprises a multiple multi-symbol convolutional syndrome former, each implementing the method disclosed above, and exchanging information on syndrome symbols.

In a further aspect, the invention relates to a decoder of codewords *c* generated by a transmission encoder using a recursive convolutional code with puncturing, said codewords *c* comprising *K* source symbols and *M* parity symbols, comprising decoding means of a multi-symbol convolutional syndrome former, implementing the method disclosed above.

In a further aspect, the invention relates to a computer program product comprising instructions for implementing the method disclosed above when this program is executed by a processor.

### List of figures

Further features and advantages of the invention will become clearer from the following description of particular embodiments and the figures, including:
- Figure 1 illustrates an example of a binary RSC encoder with polynomial *gᵣ* = [1*,* 1, 0, 1] and *gₚ* = [1, 0, 1, 1];
- Figure 2 shows an example of an implementation of the tail-biting method;
- Figure 3 is a simplified flowchart illustrating the methodology according to an embodiment of the invention;
- Figure 4 is a representation of a proposed dual encoder implementation of a TB-RSC with polynomial *gᵣ* = [1, 1, 0, 1] and *gₚ =* [1, 0, 1, 1] as illustrative example;
- Figure 5 illustrates an example of a decomposition of the syndrome former matrix *S* for *K* = 32 and *r =* 4/5;
- Figures 6a and 6b illustrate respectively the general structure of a non-recursive multi-symbol convolutional syndrome former (figure 6a) and of a recursive multi-symbol convolutional syndrome former (figure 6b);
- Figures 7a, 7b and 7c illustrate a multi-symbol convolutional syndrome former for *K =* 20 and *r =* 4/5, respectively:
   ∘ Figure 7a: Syndrome former matrix S;
   ∘ Figure 7b: Internal connections of LTB;
   ∘ Figure 7c: Multi-symbol convolutional syndrome former;
- Figure 8a to 8e illustrate a Multi-symbol convolutional syndrome former for K = 22 and M = 4, respectively:
   ∘ Figure 8a: Syndrome former Matrix *S*;
   ∘ Figure 8b: Internal connections of *T*₀;
   ∘ Figure 8c: Internal connections of *T*₁;
   ∘ Figure 8d: Internal connections of *T*₂
   ∘ Figure 8e: Multi-symbol convolutional syndrome former;
- Figure 9 is a graph representation based on base graphs interconnected in cascade and connected to source and parity nodes through interconnection networks. The dashed lines indicate edge connections between pair of nodes depending on step 3 outcome;
- Figure 10 illustrates an example of graph obtained for the TB-RSC encoder with polynomials *gᵣ =* [1, 1, 0, 1], *gₚ* = [1, 0, 1, 1], for *K* = 22*, M =* 4 and transmission mask *m*[*t*] = 7*t,* $t ∈ \left〚0,M-1\right〛$;
- Figure 11 illustrates the iterative decoding of the decomposed convolutional code (CC) ;
- Figure 12 shows the BER performance of a decomposed CC of rate 7/9 with *K* = 57 bits;

- Figure 13 illustrates a structure of a turbo decoder using decomposed CCs;
- Figure 14 shows the performance (BER and FER) of turbo decoding using or not decomposed CCs for *K =* 57 and *r =* 7/11 using the MLM approximation for MAP decoding and a maximum number of turbo iterations itₘₐₓ = 8.

### Description of embodiments in relation with the figures

### 1) NOTATIONS AND DEFINITIONS

### A. Vectors and matrices

Variables in bold small letter represent vectors (example: *x*). Variables in bold big letter represent matrices (example: *X*).

The element at index *i* of a vector *x* is denoted by *x*[*i*], with the indexing starting at *i* = 0. We also adopt modular indexing for vectors: for a length-*L* vector *x, x*[*i*] = *x*[mod*_{L}*(*i*)]*.* Therefore, negative indexing is allowed, with indices *-i* and *L-i* corresponding to the same element.

The element at row index *i* and column index *j* of a matrix *X* is denoted by *X*[*i, j*], and follows the same modular indexing convention used for vectors.

### B. Standard operators

The concatenation of two vectors *x* and *y* is denoted by [*x, y*]. The operator † is the vector or matrix transpose operator (example: *X*^{†}).

### C. Defined operators

For a length-*L* vector *x, x̅* is the vector with its element order reversed: ${x}^{←} \left[i\right] ≜ x \left[-i-1\right] , i ∈ \left〚0,L-1\right〛 .$

The operator 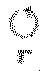 performs a rotation by *r* positions, to the left if *r* > 0 (*r* first positions become last) or to the right if *r* < 0 (*r* last positions become first), on the elements of a length-*K* vector *x:* ${↺}_{r} \left(x\right) \left[i\right] ≜ x \left[i-r\right] .$ (1)

The inner sequence of a length-*L* vector *x,* denoted by ⊏(*x*), is a length-L' ≤ *L* vector corresponding to the largest sequence (having the highest number of elements) among the sequence in *x* that starts and terminates with a non-zero element: $x = \left[0,…,0,⊂\left(x\right),0,…,0\right] ,$ (2) $s . t . ⊂ \left(x\right) \left[0\right] \neq 0 , ⊂ \left(x\right) \left[-1\right] \neq 0 .$ (3)

### 2) ENCODER DESCRIPTION

### A. Base rate RSC Encoder

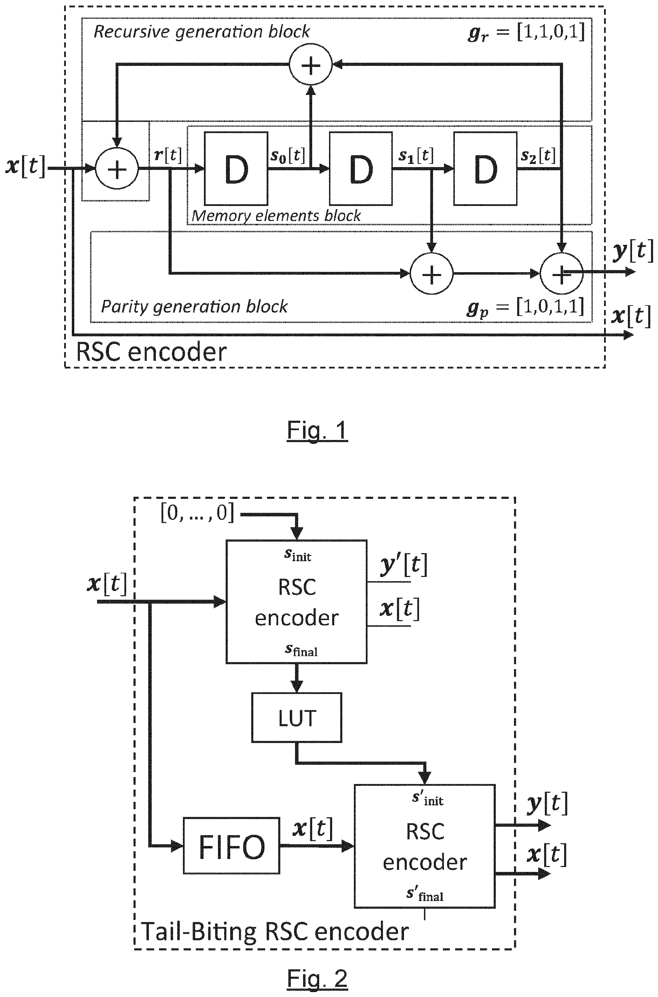

Consider a rate-1/2 binary recursive systematic convolutional (RSC) encoder with recursive polynomial *gᵣ* and parity polynomial *gₚ*, both expressed as a vector of length 1+*v*, where v is the memory depth of the encoder. The input of this encoder is a source sequence of *K* symbols, denoted by *x* as a 1 × *K* vector, each element corresponding to a symbol value being encoded. The encoding process generates a total of 2*K* symbols, referred to as codeword, that can be divided into 2 separate set of symbols, each of length *K*. Due to its systematic nature, the first set corresponds to the set of original input (source) symbols *x,* and the second set corresponds to *K* parity symbols, denoted by *y,* generated from the structure presented in Figure 1, illustrating an example of a binary RSC encoder with polynomial *gᵣ* = [1, 1, 0, 1] and *gₚ* = [1, 0, 1, 1]. For binary encoders, each symbol can take 2 different values, and in this particular case they are referred as bits. The figures presented in this document consider binary encoders for illustrative purpose. Note that the set of *source* symbols *x* is often known as *systematic* symbols. In this document, the terminology *source* is preferred instead of *systematic* for being more explicit regarding the nature of these symbols (copy of the original input symbols).

The encoding procedure is usually performed serially, the symbols in the source sequence *x* being injected at the encoder input one by one at successive time instants *t,* starting at *t =* 0 from the first symbol in the sequence, *x*[0], up to *t = K -* 1 with the last symbol in the sequence, *x*[*K-*1]*,* or equivalently *x*[-1]*.* Within the encoder structure, three blocks can be identified:
*1) Memory Elements Block:* It is composed of *v* serially chained Memory Elements (MEs), identified by blocks *D* in Figure 1. Each ME in the chain stores a single symbol at each instant *t.* The input symbol *r[t]* of the ME chain is called the recursive symbol and is generated by the recursive polynomial of the RSC encoder. The content (output) of ME number *i, i* ∈ [0, *v* - 1], in the ME chain at time *t* is *sᵢ*[*t*]*.* Since the MEs are chained, the content of the ME number *i* at time instant *t* is forwarded to the next ME (*i* + 1) at the next time instant *t*+1. Therefore, we have *s*_{*i+*1}[*t+*1] = *sᵢ*[*t*] for *i* < *v* - 1. The contents of the MEs at time *t* constitutes the encoder state at time *t.*
   Prior to encoding, the register contents is initialized with a configurable initial state symbols vector *s*ᵢₙᵢₜ of length *v.*
*2) Recursive Generation Block:* This block takes *x*[*t*] as input and a subset of the state symbols *sᵢ*[*t*] from the MEs output. The subset of chosen state symbols is determined by the non-zero values of the recursive polynomial (due to the recursive nature of the encoder, the first symbol of the recursive polynomial binary representation is always non-zero) *gᵣ*: the (*i* + 2)^{th} symbol of *gᵣ* indicates whether the symbol state *i* (*sᵢ*[*t*]) is used as input or not.

For instance, in Figure 1, the recursive polynomial is *gᵣ* = [1, 1, 0, 1], where bits with indexes 1 and 3 have value 1, indicating that state bits *s*₀[*t*] and *s*₂[*t*] are both connected to the recursive generation block, whereas bit with index 2 of *gᵣ* at value 0 indicates that state bit *s*₁[*t*] is not connected.

For binary encoders, the output of the recursive generation block is the recursive bit *r[t]* calculated by a bit-wise XOR (⊕), or modulo 2 sum) operation applied to all bits connected to the input of this block: $r \left[t\right] = x \left[t\right] ⊕ \left[{⊕}_{i = 0}^{ν - 1}\left({g}_{r}\left[i+1\right]⊗{s}_{i}\left[t\right]\right)\right]$ (4) with ⊗ being, in this context, a AND operation between 2 bits.

*3) Parity Generation Block:* This block takes as input a subset of symbols composed of the recursive symbol *r[t]* and the state symbols *sᵢ*[*t*] from the register outputs. This subset of chosen state symbols is determined by the parity polynomial *gₚ*, where the symbol with index (*i +* 1) in *gₚ* indicates whether *sᵢ*[*t*] is used as input or not, and the first symbol of *gₚ* (index 0) indicates if the recursive bit *r[t]* is taken as input of not. For instance, in Figure 1, the parity polynomial is *gₚ* = [1, 0, 1, 1]: the bits at indexes 0, 2 and 3 bits have value 1, indicating that the recursive bit *r[t]* and the state bits *s*₁[*t*] and *s*₂[*t*] are all connected to the parity generation block, whereas state bit *s*₀[*t*] is not connected because the bit at index 1 in *gₚ* is set to 0.

For binary encoders, the output of the parity generation block is the parity bit *y*[*t*] calculated by a bit-wise XOR (⊕, or modulo 2 sum) operation applied to all the bits connected as input to this block: $y \left[t\right] = r \left[t\right] {g}_{p} \left[0\right] ⊕ \left[{⊕}_{i = 0}^{ν - 1}\left({g}_{p}\left[i+1\right]⊗{s}_{i}\left[t\right]\right)\right] ,$ (5) with ⊗ being, in this context, a AND operation between 2 bits.

The behavior of the encoder over time can be represented by its trellis: the trellis is a graphical representation that describes how the encoder state evolves over time based on the inputs to the recursive generation block. Each transition between two states is associated with specific input and output (parity) values, determined by the encoder's structure. The trellis unfolds step by step, illustrating all possible input/output paths.

If the source sequence symbols are not binary sequences and belong to an alphabet Ω (generally a list of position integers including 0 and 1), it is possible to build a non-binary RSC encoder if the following mathematical properties is ensured on the product and sum ⊕ of any symbols (*a, b*) ∈ Ω²:
- *a* ⊗ *b = b* ⊗ *a, a* ⊗ *b* ∈ Ω, *a* ⊗ 0 *=* 0*, a* ⊗ 1 *= a,*
- *a* ⊕ *b = b* ⊕ *a, a* ⊕ *b* ∈ Ω*, a* ⊕ 0 *= a,*
- The multiplication ⊗ is distributive with respect to the addition ⊕.

Then, the source, parity, states, recursive symbols all take values in the alphabet Ω, and both equations (4) and (5) still apply for non-binary encoders by using the corresponding symbols sum ⊕ and product ⊗.

### B. Return-to-zero (RTZ) sequences

Since convolutional codes (CCs) and their concatenations (including turbo codes) are linear codes, to determine the Hamming distances between coded sequences (codewords) amounts to determining the Hamming distances between the non-zero codewords and the "all-zero" codeword. Therefore, the Hamming distance spectrum of the code can be obtained by calculating the Hamming weight of the codewords that leave state [0, ..., 0] in the trellis and return to it. These codewords are called RTZ codewords. Similarly, source sequences generating RTZ codewords are called RTZ sequences. In particular, the minimum Hamming distance of the code will be provided by short RTZ sequences.

### C. Tail-biting termination technique

One weakness of the RSC encoder described in the previous section is that the final state symbols do not terminate with a known value when encoding the last symbols. This implies that these symbols are not well protected by the last generated parity symbols. To alleviate this problem, a technique called tail-biting (TB) [1], [2] (references are listed in Appendix B) is applied to ensure that the v MEs in the RSC encoder start and terminate with the exact same content, i.e. *sᵢ*[0] *= sᵢ*[*K -* 1] = *sᵢ*[*-*1]*,* Vi ∈ [0, *v* - 1].

Note that the tail-biting termination is only possible if the number of input symbols *K* is not a multiple of the encoder impulse response period *p*: *modₚ*(*K*) ≠ 0. Otherwise, an additional padding symbol must be added as input. If the recursive polynomial *gᵣ* is prime, *p* is equal to 2*^{v}* - 1.

*Example of tail-biting implementation (not part of the invention):* To achieve such a feature, a simple scheme is shown in Figure 2 [2] for binary encoders.
1) **Pre-processing step:** The input sequence *x* is firstly encoded by an RSC encoder following the method described in Section 2.A. The initial bit states of this first encoding procedure are set to *s*ᵢₙᵢₜ = [0, ... , 0].
   During this encoding, the bits of the input sequence *x* that successively enter the RSC encoder are, at the same time, stored into a memory of type first-in first-out (FIFO). After *K* time steps (*t = K -* 1), the encoding procedure is terminated and the content of the v state bits, *s*_{final} = [*sᵢ*[*-*1]]_{*i∈*[0*,v-*1]} is extracted and forwarded to a look-up table (LUT). This LUT maps the final state bits of the first RSC encoder to new state bits values that serves to initialize the register contents of a second RSC encoder, *s'*ᵢₙᵢₜ.
2) **Actual encoding:** Once the register of the second RSC encoder is initialized with *s*'ᵢₙᵢₜ , the contents of the FIFO is forwarded to the second RSC encoder which generates the final source bits *x* and parity bits *y*. The codeword c consists of the concatenation the source bits and the parity bits in a single vector. By convention, we will consider in this document that source bits are transmitted first, so they are in the first positions in the codeword: *c =* [*x, y*].

### D. Other termination techniques

Apart from TB, there exist two other types of terminations:
1) *Zero termination:* v additional source symbols are appended at the end of the source sequence, such that, after RSC encoding, the state symbols terminate at zero: *s*_{final} = **0.** Note that *v* parity symbols are also generated during the termination phase.
2) *Truncated termination:* the encoding phase is carried out without taking into account the final state. Since this final state is unknown, it generally comes with a degradation of the error rate at the end of the data sequence when decoding.

In fact, these techniques can be seen as particular cases of TB. The zero termination case can be represented as TB-RSC encoding *K* + *v* symbols, with the last *v* symbols chosen such that the state terminates at zero. The truncated termination case can be modeled as a zero-terminated RSC encoder where the last *v* source and parity symbols are discarded, or *punctured* (see next section).

### E. Puncturing and codeword transmission

To support high throughput communications, the number of transmitted symbols can be reduced by discarding a subset of the symbols generated after encoding. This procedure is termed *puncturing.* Although source (*x*) and parity (*y*) symbols can be punctured, it is more common to puncture parity symbols, especially when the RSC code is used as the constituent code of a turbo code. This is because, for a turbo code, each source symbol is used to decode the two constituent codes, whereas each parity symbol is only used by one elementary decoder. Puncturing a source symbol is therefore more penalizing than puncturing a parity symbol in the decoding process. The positions of the encoded parities retained for transmission can be determined by a parity transmission mask represented by a length-*M* vector *m,* where each element indicates the position of a parity symbol kept for transmission, and the remaining positions are discarded. For convenience, the element in *m* are sorted in ascending order: 0 ≤*m*[*t*] *< m*[*t +* 1] ≤ *K - 1, ∀t ∈* [0*, M* - 1]. The (*K* - *M*) discarded parity positions are sorted in ascending order and given by the vector *m̅*.

Thus, if *z* is the remaining parities to be transmitted after puncturing, we have $z \left[t\right] = y \left[m\left[t\right]\right] , t ∈ \left[0,M-1\right] .$ (6)

For instance, if the parity sequence at the output of the encoder is *y* = [1, 0, 1, 0, 0, 1, 0, 1] and the transmission mask is *m* = [0, 2, 6], then the transmitted parity bits after puncturing are the 1^{st}, 3^{rd} and 7^{th} bits of *y,* giving *z* = [1, 1, 0]. The punctured positions vector is given by *m̅* = [1, 3, 4, 5, 7].

The codeword after puncturing thus becomes *c̃* = [*x*, *z*], and the resulting code rate is equal to *R = K* / (*K+M*) ≥ 1/2.

### F. Specific case: rate R = r/(r + 1) punctured encoders

Although any transmission mask can be defined, it is convenient to define a *regular* transmission pattern where 1 parity symbol every *r* symbols (*r >* 1) is retained for transmission. The transmission mask then becomes *m[t] = rt + o*ᵢₙᵢₜ, with *o*ᵢₙᵢₜ *∈*[0, *r -* 1] being an initial transmission offset.

A case that becomes relevant for the invention is when the transmission period *r* is equal to the convolution period of the encoder *p* = 2*^{v}* - 1. We will see that the invention is of maximum interest in this case, since, through an alternative representation of the encoder, such a specific pattern can be decoded with minimal computational complexity.

### 3) STATE-OF-THE-ART DECODERS

### A. Standard decoding of convolutional codes

*1) Decoder families:* Convolutional codes have been extensively employed in various modem communication systems due to their straightforward encoder structure. The primary complexity in systems utilizing convolutional coding lies within the decoder. Numerous decoding algorithms have been developed to optimize decoding performance efficiently. Two prominent decoding algorithms are the Viterbi Algorithm (VA) [3], [4] and the maximum *a posteriori* probability (MAP) algorithm, originally proposed by Bahl, Cocke, Jelinek, and Raviv in 1974 [5]. The VA involves identifying the optimal path in a trellis-based graph to minimize sequence error probability, producing hard-decision outputs that estimate the transmitted information symbols. In contrast, the MAP algorithm performs symbol-by-symbol decoding, achieving optimal symbol error probability. The BCJR algorithm was largely overlooked for nearly a decade due to its higher complexity compared to the VA. It regained attention in the early 1990s for its ability to compute soft outputs containing the *a posteriori* probabilities (APPs) of transmitted binary symbols, which are essential for decoding concatenated convolutional codes such as turbo codes or serially concatenated codes. Although the VA can be adapted to deliver APPs [6], [7], only the MAP algorithm achieves optimal symbol error rate (SER) performance. The MAP algorithm as presented in [5] involves forward and backward recursions in the trellis diagram of the code and requires a large number of operations, including exponential calculations and multiplications, to compute the probabilities of current states and information symbols. Rewriting the decoding algorithm in the logarithmic domain (Log-MAP) [8] simplifies processing, since multiplications are converted into additions, which are computationally simpler. The soft estimates provided by the Log-MAP decoder are then proportional to the logarithms of the APPs. Addition- ally, the Max-Log-MAP algorithm [8] significantly reduces the computational complexity of the Log-APP algorithm by approximating the logarithm of sums of exponentials by a maximum operator, at the cost of a small performance loss. The Max-Log-Map algorithm is most commonly used in software and hardware implementations.

Other SISO algorithm families have also been investigated to decode convolutional codes and their concatenation, such as belief propagation which is currently used for decoding low-density parity-check (LDPC) codes. However, up to now, these solutions have not provided any significant simplification compared with previous solutions and are not able to achieved MAP performance [9].

### 2) High-level description of the Max-Log-MAP algorithm (binary case) [8]:

- Forward and backward recursions: For each trellis state *j* and at each trellis step *i,* the forward and the backward metrics *α* and *β* are computed using the branch metrics *γ* as: ${α}_{i} \left(j\right) = {max}_{j ′ ∈ {S}_{j}} \left({α}_{i - 1}\left(j′\right)+{γ}_{i - 1}\left(j′,j\right)\right)$ (1) ${β}_{i} \left(j\right) = {max}_{j ′ ∈ S {′}_{j}} \left({β}_{i + 1}\left(j′\right)+{γ}_{i}\left(j,j′\right)\right)$ (2) *Sⱼ* and *S*'*ⱼ* are the sets of trellis states at steps *i* -1 and *i +* 1, respectively, that are connected to state *j* at trellis step *i.* Metrics *γᵢ* take into account all possible combinations of source and parity symbols between trellis states.
- The soft output (APP) is calculated as a log-likelihood ratio (LLR) at step or time index *i*: $\begin{matrix}{L}_{i} = {max}_{\left(j,j′\right) ∈ {\left\{0,…{, 2}^{ν}\right\}}^{2} , s \left(j,j′\right) = 0} \left({α}_{i}\left(j\right)+{β}_{i + 1}\left(j′\right)+{γ}_{i}\left(j,j′\right)\right) \\ - {max}_{\left(j,j′\right) ∈ {\left\{0,…{, 2}^{ν}\right\}}^{2} , s \left(j,j′\right) = 1} \left({α}_{i}\left(j\right)+{β}_{i + 1}\left(j′\right)+{γ}_{i}\left(j,j′\right)\right)\end{matrix}$ (3) where v is the memory of the considered convolutional code and *s*(*j, j'*) is the source bit that connects state *j* at trellis step *i* to state *j*' at trellis step *i +* 1, if the connection exists. When aiming for high throughput, several trellis sections can be decoded together. Precisely, a radix-2*^{q}* trellis allows the decoding of *q* bits at each decoding step. The previous equations have then to be adapted accordingly. Additionally, for high-throughput decoding, the data frames are in practice decomposed into windows of size *W,* processed in parallel.

*3) Rate adaptation:* Conventionally, when rate adaptation is achieved by puncturing, the decoding process of the punctured code is identical to decoding process of the code with the base rate, using the full trellis and the equations described above. LLRs corresponding to the punctured symbols, i.e. those not transmitted, are set to 0 at the input of the decoder. If the coding rate is fixed, it is possible to optimize the decoding process by excluding the punctured symbols when calculating the *γ* metrics, but this only marginally reduces decoding complexity.

To summarize, with conventional state-of-the-art decoders, the decoding complexity of a punctured RSC code is similar to the decoding complexity of the base rate code.

### 4) DESCRIPTION OF THE INVENTION

### A. General overview of the invention

The aim of the invention is to propose a method to decode codewords generated by a punctured TB-RSC encoder with much lower computational complexity than the state-of-art decoders in terms of number of operations per seconds (computer program), circuit area (dedicated processor) and/or energy consumption (computer program and dedicated processor), while keeping similar level of error-rate performance.

The core of the invention is to find a syndrome former that leverages the dual code representation of the punctured TB-RSC encoder, such that this syndrome former can be identified with structures adequate for decoding using known algorithms such as message-passing algorithm (MPA), maximum a posteriori (MAP) or Viterbi algorithm (VA). Describing encoding structures of codes in the dual domain is of high interest for high code rates, because the number of constraints is reduced compared to the original domain. Indeed, in the original domain, *K* symbols are encoded to output a codeword of *K + M* symbols, whereas in the dual domain, *M* symbols are encoded to output *K + M* and *M << K* in the case of high coding rates.

The syndrome former matrix is obtained by the concatenation of several dual codewords, each comprising a set of *M* dual source symbols and a set of *K* dual parity symbols. The dual codewords are constrained to comprise a single non-zero sub-codeword, such that the syndrome computation can be applied locally on the non-zero sub-codeword of each constrained dual codeword.

The definition of a sub-codeword is as follows. Consider an encoder generating codewords composed of *K* source symbols and *M* parity symbols. Define a sequence *x =* [*x_{sub},* 0*_{K-K'}*] comprising a first part *x_{sub}* of *K'* < K symbols followed by a second part of *K - K'* zero-valued symbols. Then, *c_{sub}* = [*x_{sub}, y_{sub}*] is a sub-codeword composed of *K'* source symbols *x_{sub}* and *M'* parity symbols *y_{sub}* if encoding *x =* [*x_{sub},* 0*_{K-K,}*] (or any circularly shifted version of this sequence), generates a codeword c = [*x, y*] having a set of parity symbols *y =* [*y_{sub}*, 0*_{M-M'}*] comprising a first part of *M' < M* parity symbols *y_{sub}* followed by a second part of *M* - *M'* zero-valued symbols (or any circularly shifted version of this part).

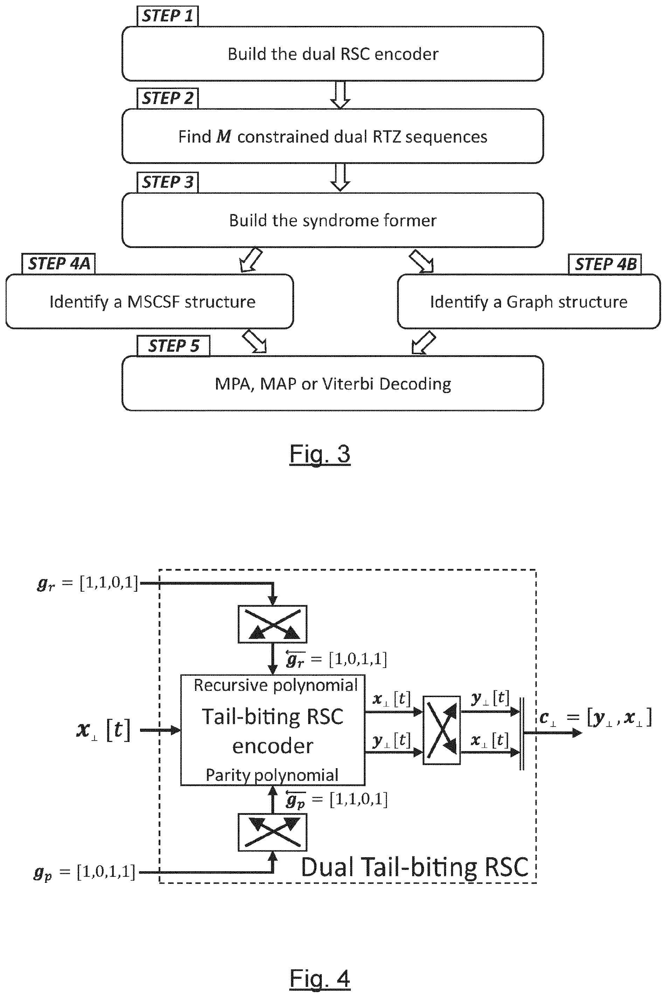

If dual codewords are generated by a dual encoder that is equivalent to an RSC encoder with puncturing, then finding dual codewords comprising a single non-zero sub-codeword is equivalent of searching for RTZ sequences in an RSC code (see Section 2-B for the definition of RTZ sequences). Indeed, encoding an RTZ sequences produces a codeword composed of a single non-zero sub-codeword. Based on this property, five steps, illustrated in Figure 3, are identified to find syndrome former structures suitable for decoding:
- **Step 1:** Build a dual code representation of the TB-RSC encoder used to transmit codewords, without considering any puncturing.
- **Step 2:** Use the dual TB-RSC encoder, built in the previous step, to find a list of *N*_{*seq*_{⊥}} constrained dual RTZ sequences, such that *M - 1* ≤ *N*_{*seq*_{⊥}} ≤ *M.*
- **Step 3:** Build the syndrome former matrix by encoding, puncturing and combining the *N*_{*seq*_{⊥}} constrained dual RTZ sequences using the dual TB-RSC encoder.
- **Step 4A:** Construct the multi-symbol convolutional syndrome former (MSCSF) encoding structure based on the *N*_{*seq*_{⊥}} encoded sequences obtained in Step 3.
- **Step 4B:** Construct a graph structure based on the *N*_{*seq*_{⊥}} encoded sequences obtained in Step 3.
- **Step 5:** Decode using MPA, MAP or Viterbi algorithms.

Steps 1, 2 and 3 aim to find a set of *N*_{*seq*_{⊥}} dual codewords which serves as a basis for the dual representation of the punctured TB-RSC encoder. When these dual codewords are combined, it is possible to identify either an MSCSF structure (step 4*A*) or a graph structure (step 4*B*), both suitable for decoding (step 5) with known algorithms such as MPA, MAP or VA. The computational complexity of these algorithms is strongly correlated with the density of non-zero symbols in the combined dual codewords and, consequently, with their density in the constrained dual RTZ sequences generated in step 2. Notably, a higher occurrence of non-zero symbols lead to an increased number of MEs in the MSCSF representation, as well as more edge connections in the graph representation. Therefore, selecting appropriate constrained dual RTZ sequences in step 2 is crucial for achieving a low-complexity decoder.

The next subsections provide in-depth technical details on how these steps are carried out.

### B. Step 1: Build a base-rate dual TB-RSC encoder

*1) Definition:* The dual code of a linear code *C* with rate *k*/*n, C*_{⊥}, is a linear code of rate (*n - k*)/*n* whose codewords are orthogonal to the codewords of *C*. If ***G*** (*k* × *n* matrix) is the generator matrix of *C* in standard form, *G* = [*Iₖ* |*A*], where *A* is a *k* × (*n-k*) matrix, then the parity-check matrix (PCM) of *C*, *G*_{⊥} *=* [*-A*^{†} |*Iₙ₋ₖ*]*,* where *A*^{†} is the transpose matrix of *A*, is a generator matrix of *C*_{⊥}.
*2) Deriving the dual of an RSC code:* Consider a TB-RSC encoder with coding rate 1/2 and recursive/parity polynomials (*gᵣ, gₚ*)*.* The rate- 1/2 TB-RSC encoder with recursive/parity polynomials (*g̅ᵣ̅*, *g̅ₚ̅*) having their element order reversed with respect to the polynomials of the original encoder is a dual encoder of the original code.

To illustrate with an example, let the TB-RSC polynomials be *gᵣ* = [1, 1, 0, 1] and *gₚ* =[1, 0, 1, 1]. The polynomials of the dual TB-RSC encoder are *g̅ᵣ̅* = [1, 0, 1, 1] and *g̅ₚ̅* = [1, 1, 0, 1]. In this particular but practical case, the role of the recursive and parity polynomials is exchanged, but this is not true in general. The dual TB-RSC encoder outputs a dual codeword composed of a set of *K* dual source symbols *x*_{⊥} and a set of *K* dual parity symbols *y*_{⊥}. The dual codeword is the concatenation of these two sequences, with the dual parity symbols being transmitted first: *c*_{⊥} = [*y*_{⊥}, *x*_{⊥}]*.* Recall that, in the original TB-RSC encoder, *c* = [*x, y*], i.e., the *K* source symbols *x* is concatenated before the *K* parity symbols *y* in the generated codeword before puncturing. Consequently, in the resulting dual encoder, the positions of the dual source and dual parity symbols are reversed compared to their positions in the original codeword. The structure of the dual encoder is illustrated in Figure 4.

A generator matrix of the base-rate dual code, *G*_{⊥}, can be obtained through the method described in Section 4.B.1), applied to the dual encoder structure previously described. This matrix form is convenient for a compact mathematical description of the encoding process, as *c*_{⊥} = *x*_{⊥}*G*_{⊥}*.*

Note that dual encoders are never unique for a given code. However, the dual encoder built in this section is actually a unique dual encoder structure that fulfills two characteristics fundamental to the invention:
1) It is directly derived from the encoding structure of the original TB-RSC code.
2) The positions of dual source symbols *x*_{⊥} in the dual codewords *c*_{⊥} are aligned with the positions of dual parity symbols *y* in the original 1/2-rate codeword *c* (before puncturing).

### C. Step 2: Find a set of constrained dual RTZ sequences

As a reminder, the elements of vectors *m* and *m̅* respectively indicate the positions of transmitted and punctured parity symbols after the generation of the *K* parity symbols *y* with the base rate RSC encoder (see Section 2.E).

Let *rₙ* = *m*[*n*]*, n ∈* [0, *M -* 1], be the position of the *n*^{th} transmitted parity symbol in *y.* Step 2 involves searching for *M -* 1 ≤ *N*_{*seq*_{⊥}} ≤ *M* input dual sequences *x*^{⊥}, where the following 3 constraints (*C*₁, *C₂, C*₃) must be satisfied, *∀n ∈*[0, *N*_{*seq*_{⊥}} *-*1]*:* ${x}_{n}^{⊥} \left[\overline{m}\left[t\right]\right] = 0 , t ∈ \left〚0,K-M-1\right〛$.The elements in ${x}_{n}^{⊥}$ must be equal to 0 at all positions matching the positions of all punctured parity symbols given by *m̅* ${↺}_{{r}_{n}} \left({x}_{n}^{⊥}\right)$ (The 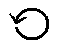 operator is defined in Section 1 and rotates the elements in a vector) is an RTZ sequence for the dual TB-RSC code. By definition, a length-*K* non-zero symbol sequence *x* is an RTZ sequence of a given TB-RSC code if, starting from initial state *s*'*ᵢₙᵢₜ*= 0, all the state symbols are equal to 0 after encoding. Therefore, the sequence *x*^{⊥} having its element positions rotated by *rₙ* must terminate all state symbols at 0 after encoding. Note that an RTZ sequence always produce, after encoding, a codeword comprising a single non-zero sub-codeword. ${↺}_{{r}_{n}} \left({x}_{n}^{⊥}\right) \left[0\right] \neq 0$: The first symbol of the sequence *xₙ*^{⊥} rotated by *rₙ* must be different from zero. This constraint ensures that each constrained dual RTZ sequences are all linearly independent from each other.

Appendix A presents an example of a methodology to find sequences satisfying these constraints.

Depending on the puncturing choice, there may be multiple vectors *xₙ*^{⊥} that satisfy constraints (*C*₁, *C₂, C*₃)*.* The set of solutions *xₙ*^{⊥} can be appended in a list *χₙ.*

However, only one solution from this list should be selected. The selection criteria should aim to find an equivalent encoding structure suitable for low-complexity decoding. The following are possible selection criteria (*S*ₓ) that align with this goal:
*S*₁: Smallest inner sequence length - as defined in Section 1, the inner sequence of a vector *x* is a vector ⊏(*x*) corresponding to the largest sequence in *x* that starts and terminates with a non-zero element. Therefore, this criterion selects the sequences *xₙ*^{⊥} having the smallest inner sequence length: ${X}_{n} ← {arg min}_{{x}_{n}^{⊥} ∈ {X}_{n}} l \left(⊂\left({x}_{n}^{⊥}\right)\right)$ (8)
*S*₂: Lowest input weight - the weight of a vector *x,* denoted *w*(*x*), is equal to the number of non-zero elements in *x* (< > is the Iverson bracket notation): $w \left(x\right) = {\sum }_{t = 0}^{K - 1} \left〈x\left[t\right]\neq 0\right〉$ (9) Therefore, this criterion selects the sequences *xₙ*^{⊥} having the lowest weight: ${X}_{n} ← {arg min}_{{x}_{n}^{⊥} ∈ {X}_{n}} w \left({x}_{n}^{⊥}\right)$ (10)
*S*₃: Lowest output weight - same criterion type as *S*₂ but applied to the output codeword obtained after encoding *xₙ*^{⊥} with the dual-TB-RSC encoder obtained in step 1: ${X}_{n} ← {arg min}_{{x}_{n}^{⊥} ∈ {X}_{n}} w \left({x}_{n}^{⊥}{G}_{⊥}\right)$ (11)

One or several of these selection criteria can be successively applied if the list of solutions is still not unique, i.e. |*χₙ*|*>* 1 with |.| being the number of elements in a list. In case more than one solution remain after applying all criteria, one solution can be selected randomly from the remaining ones in the list *χₙ.* It is also possible that, for puncturing patterns being a multiple of the convolutional period p, no solutions are found when searching for the last (*N*_{*seq*_{⊥}}*^{th}*) sequence ( ${χ}_{{N}_{{seg}^{⊥}} - 1} = ∅$)*,* i.e. it is not possible to find a valid sequence that meets all the aforementioned constraints. In this case, only *N*_{*seq*_{⊥}} = *M -* 1 constrained dual RTZ sequences are generated.

### D. Simplified step 2 for the specific case of coding rate r/(r+1) codes

In this section, we consider the specific case of rate-*r*/(*r*+1) punctured TB-RSC encoders with a regular transmission mask (see Section 2-F). In a first approach, but without loss of generality, we consider that the first transmitted parity symbol is the first parity symbol generated by the base-rate encoder (*z*[0] = *y*[0], therefore, there is no initial position offset: *o*ᵢₙᵢₜ = 0).

Assuming mod*ᵣ*(*K*) = 0, it is then sufficient to find the first dual constrained RTZ sequence *x*₀^{⊥} following the general step 2 method at *n* = 0, and then deduce the *N*_{*seq*_{⊥}}-1, remaining sequences with a right-hand rotation of *x*^{⊥} by multiples of *r:* ${x}_{n}^{⊥} = {↺}_{- nr} {x}_{0}^{⊥} , for n ∈ \left〚0,{N}_{{seq}^{⊥}}-1\right〛 .$ (12)

These sequences are guaranteed to respect the 3 constraints (*C*₁, *C*₂*, C*₃)*.*

If mod*ᵣ*(*K*) ≠ 0, then the regularity of the transmission mask is locally broken for the last transmitted parity symbols due to tail-biting: *m*[*0*]*≠ m*[*-*1] *+ r.* This affects the last *L*ₗₐₛₜ sequences where it is required to apply the general step 2 methodology to find the last *L*ₗₐₛₜ constrained dual RTZ sequence *x*^{⊥}*, n =* [*N*_{*seq*_{⊥}} -*L*ₗₐₛₜ, *N*_{*seq*_{⊥}}*-*1]. The previous *N*_{*seq*_{⊥}} - *L*ₗₐₛₜ constrained dual RTZ sequences can be found using the same method as for the mod*ᵣ*(*K*) = 0 case described above, i.e. applying equation (12) for *n* ∈[1, *N*_{*seq*_{⊥}} -*L*ₗₐₛₜ -1].

The search for constrained dual RTZ sequences is further simplified if *r = p, p* being the convolution period of the dual encoder, where ${x}_{0}^{⊥} = \left[1,{{0 , … , 0}_{︸}}_{\times \left(p-1\right)},1,0,…\right]$ (13) is the first constrained dual RTZ sequence which satisfies all 3 selection criteria *S*₁, *S*₂ and *S*₃ presented in Section 4-C. For this particularly case, the number of dual constrained RTZ sequence is *N*_{*seq*_{⊥}} *= M -* 1. Indeed, we have mod*ₚ*(*K*) ≠ 0 since is not possible to find a TB-RSC encoder having a number of source symbols *K* being a multiple of *p* (See Section 2.C). It is then not possible to find any sequence validating constraints (*C*₁, *C*₂*, C*₃) when *n = M -*1*.*

The remaining *M* - 2 sequences are deduced through a right-hand rotation of *x*₀^{⊥} by multiples of *p*, accordingly to equation (12).

When *o*ᵢₙᵢₜ ≠ 0, the method is mostly unchanged. The *N*_{*seq*_{⊥}} sequences are first obtained by assuming an alternative transmission mask *m'* without any initial offset, then the obtained sequences are rotated to the left by *o*ᵢₙᵢₜ so that they align with the original mask.

### E. Step 3: Build the syndrome former matrix

The constrained dual RTZ sequences ${x}_{n}^{⊥}$*, n ∈*[0, *N*_{*seq*_{⊥}} - 1], obtained in step 2 (Section 4.C or 4.D) are encoded using the dual TB-RSC encoder obtained in step 1 (Section 4.B) to generate codewords ${c}_{n}^{⊥} = {x}_{n}^{⊥} {G}_{⊥}$ of the form ${c}_{n}^{⊥} = \left[{y}_{n}^{⊥}, {x}_{n}^{⊥}\right]$ composed of a set of dual parity symbols (first half) and a set of dual source symbols *xₙ*^{⊥} (second half). Then, each set of dual source symbols *xₙ*^{⊥} is punctured following the same transmission mask *m* as used for transmitting parities *z* with the original RSC encoder. Notice that the puncturing is applied on the dual source symbols in the dual codeword *c*^{⊥}, whereas it was applied on the parity symbols in the codeword *c.* The constrained dual codewords are then ${{c}^{˜}}_{n}^{⊥} = \left[{y}_{n}^{⊥}, {z}_{n}^{⊥}\right]$ with ${z}_{n}^{⊥} \left[t\right] = {x}_{n}^{⊥} \left[m\left[t\right]\right]$ being the set of punctured dual source symbols.

The syndrome former matrix *S* is then obtained by combining the *N*_{*seq*_{⊥}} dual punctured codewords ${{c}^{˜}}_{n}^{⊥}$, : $S = {\left[{\left({{c}^{˜}}_{n}^{⊥}\right)}^{†}\right]}_{n ∈ \left〚0,{N}_{{seq}^{⊥}}-1\right〛}$ (14) where ${{c}^{˜}}_{n}^{⊥}$ are transposed to form column vectors ${\left({{c}^{˜}}_{n}^{⊥}\right)}^{†}$ that are concatenated.

Due to the construction of *S,* when a (punctured) codeword of the original TB-RSC code *c̃ =* [*x, z*] is encoded by *S,* the output sequence is equal to the all-zero vector: ${c}^{˜} S = 0 .$ (15)

This constraint can be exploited to detect and correct errors in received codewords. For example, if a single symbol error *δ* = [0*,...*0*, e,* 0*,...,*0] is introduced in the received codeword (*c̃ₑ = c̃* ⊕ *δ*), the syndrome symbols resulting from equation (15) locally take non-zero values *S_{local}* over a limited number of positions: ***c̃**ₑ**S** = **δS** =* [0,...,0, *S_{local},* 0,...,0]. This locality property is obtained thanks to the choice of the constrained dual RTZ sequences from step 2.

In the following we show an application example of the method for the following TB-RSC binary encoder:
- Polynomials *gᵣ* = [1, 1, 0, 1] and *gₚ* = [1, 0, 1, 1],
- Regular transmission mask of rate *p*/*(p +* 1), with *p* = 2*^{v}* - 1 = 7 and *oᵢₙᵢₜ =* 0: *m*[*t*] *= t* ×*p, t ∈*[0, *M* -1],
- *K =* 22 source symbols in *x,* $M = \left⌈K/p\right⌉ = 4$ transmitted parity symbols in *z*.

The base-rate dual TB-RSC encoder (step 1) is shown in Figure 4. The *N*_{*seq*_{⊥}} *=* 3 constrained dual RTZ sequences are deduced in accordance with Section 4.D as $\begin{matrix}{x}_{0}^{⊥} = \left[1, 0, 0, 0, 0, 0, 0, 1, 0, 0, 0, 0, 0, 0, 0, 0, 0, 0, 0, 0, 0, 0\right] , \\ {x}_{1}^{⊥} = \left[0, 0, 0, 0, 0, 0, 0, 1, 0, 0, 0, 0, 0, 0, 1, 0, 0, 0, 0, 0, 0, 0\right] , \\ {x}_{2}^{⊥} = \left[0, 0, 0, 0, 0, 0, 0, 0, 0, 0, 0, 0, 0, 0, 1, 0, 0, 0, 0, 0, 0, 1\right] ,\end{matrix}$

After encoding each *xₙ*^{⊥} using the dual TB-RSC encoder, the *N*_{*seq*_{⊥}} resulting sets of dual parity bits of are $\begin{matrix}{y}_{0}^{⊥} = \left[1, 1, 1, 1, 0, 0, 1, 1, 0, 0, 0, 0, 0, 0, 0, 0, 0, 0, 0, 0, 0, 0\right] , \\ {y}_{1}^{⊥} = \left[0, 0, 0, 0, 0, 0, 0, 1, 1, 1, 1, 0, 0, 1, 1, 0, 0, 0, 0, 0, 0, 0\right] , \\ {y}_{2}^{⊥} = \left[0, 0, 0, 0, 0, 0, 0, 0, 0, 0, 0, 0, 0, 0, 1, 1, 1, 1, 0, 0, 1, 1\right] ,\end{matrix}$ (16)

And the *N*_{*seq*_{⊥}} resulting sets of punctured dual source bits are $\begin{matrix}{z}_{0}^{⊥} = \left[1, 1, 0, 0\right] , \\ {z}_{1}^{⊥} = \left[0, 1, 1, 0\right] , \\ {z}_{2}^{⊥} = \left[0, 0, 1, 1\right] ,\end{matrix}$ (17)

Finally, the syndrome former matrix is $S = \left[\begin{matrix}1 , 0 , 0 \\ 1 , 0 , 0 \\ 1 , 0 , 0 \\ 1 , 0 , 0 \\ 0 , 0 , 0 \\ 0 , 0 , 0 \\ 1 , 0 , 0 \\ 1 , 1 , 0 \\ 0 , 1 , 0 \\ 0 , 1 , 0 \\ 0 , 1 , 0 \\ 0 , 0 , 0 \\ 0 , 0 , 0 \\ 0 , 1 , 0 \\ 0 , 1 , 1 \\ 0 , 0 , 1 \\ 0 , 0 , 1 \\ 0 , 0 , 1 \\ 0 , 0 , 0 \\ 0 , 0 , 0 \\ 0 , 0 , 1 \\ 0 , 0 , 1 \\ 1 , 0 , 0 \\ 1 , 1 , 0 \\ 0 , 1 , 1 \\ 0 , 0 , 1\end{matrix}\right]$ (18)

### 5) STEP 4A: GENERATION OF A MULTI-SYMBOL CONVOLUTIONAL SYNDROME FORMER

The syndrome former matrix S can be fragmented into several blocks or sub-matrices that are processed sequentially over *N_{LTB}* instances to generate the all-zero vector. The resulting syndrome former follows a multi-symbol convolutional structure (MSCSF) that incorporates these fragmented blocks, called linear transformation blocks (LTBs).

### A. Decomposition of the syndrome former matrix S

The number of LTBs in *S* is *N_{LTB}* ≤*M* and their size is *hⱼ* × *ω* (height × width). Each LTB *Tⱼ, j E[0, N_{LTB}-* 1] is decomposed into 2 sub-blocks (sub-matrices) (*Xⱼ, Zⱼ*)*,* respectively of size ${h}_{j}^{x} \times ω$ and ${h}_{j}^{z} \times C$: ${T}_{j} = \left[\begin{matrix}{X}_{j} \\ {Z}_{j}\end{matrix}\right] .$ (19)

Both *Xⱼ* and Z*ⱼ* matrices are sub-blocks extracted from matrix *S.* For *Xⱼ,* the extraction is performed on ${h}_{j}^{x}$ successive rows among the first *K* rows in *S* and *ω* successive columns. For *Zⱼ,* the extraction is performed on ${h}_{j}^{z}$ successive rows among the last*M* rows in *S* and *ω* successive columns.

We define *C_{f}* as the *starting column position* of LTB *Tⱼ*, which corresponds to the first column position in *S* from which sub-block *Xⱼ* and *Zⱼ* are extracted. Similarly, ${R}_{j}^{x}$ is the *starting row position* of sub-block *Xⱼ* and ${R}_{j}^{z}$ is the *starting row position* of sub-block *Zⱼ.*

For a valid sub-block decomposition, we have ${X}_{j} \left[n, m\right] = S \left[n+{R}_{j}^{x},m+{C}_{j}\right] ,$ (20) ${R}_{j}^{x} ≜ {\sum }_{k = 0}^{j - 1} {h}_{k}^{x} ,$ (21) and ${Z}_{j} \left[n, m\right] = S \left[n+{R}_{j}^{z}, m+{C}_{j}\right] ,$ (22) ${R}_{j}^{z} ≜ K + {\sum }_{k = 0}^{j - 1} {h}_{k}^{z} .$ (23)

All sub-blocks *Xⱼ* must satisfy the following set of constraints:
${C}_{1}^{x}$: The accumulated height ${h}_{j}^{x}$ of all sub-blocks *Xⱼ* must be equal to the number of source symbols *K*: ${R}_{{N}_{LTB}}^{x} = K$*.*
${C}_{2}^{x}$: The LTBs must contain all non-zero elements of syndrome former matrix *S.* Consequently, the elements in row index *i* of sub-block *Xⱼ* must include all non-zero elements of the corresponding row index $i + {R}_{j}^{x}$ in *S:* $S \left[i+{R}_{j}^{x},{C}_{j}+ω+k\right] = 0 , ∀ k ∈ \left〚0,{N}_{{seq}^{⊥}}-ω-1\right〛$ (24)
${C}_{3}^{x}$: The starting column position of the *j*^{th} LTB must be circularly anterior to the starting column position of the (*j* + 1)^{th} LTB. We have, *∀j ∈*[0*, N_{LTB} -*1] $0 < {C}_{j} - {C}_{j - 1} if \left|{C}_{j}-{C}_{j - 1}\right| < \frac{M}{2}$ (24) $0 < {C}_{j - 1} - {C}_{j} if \left|{C}_{j}-{C}_{j - 1}\right| \geq \frac{M}{2}$ (25)

Similarly, all sub-blocks Z*ⱼ* must satisfy the following set of constraints:
${C}_{1}^{z}$: The accumulated height ${h}_{j}^{z}$ of all sub-blocks Z*ⱼ* must be equal to the number of transmitted parity symbols *M* : ${R}_{{N}_{LTB}}^{z} = M$.
${C}_{2}^{z}$: The LTBs must contain all non-zero elements of syndrome former matrix *S.* Consequently, the elements in row index *i* of sub-block *zⱼ* must include all non-zero elements of the corresponding row index $i + {R}_{j}^{z}$ in *S*: $S \left[i+{R}_{j}^{z},{C}_{j}+ω+k\right] = 0 , ∀ k ∈ \left〚0,{N}_{{seq}^{⊥}}-ω-1\right〛$ (27)

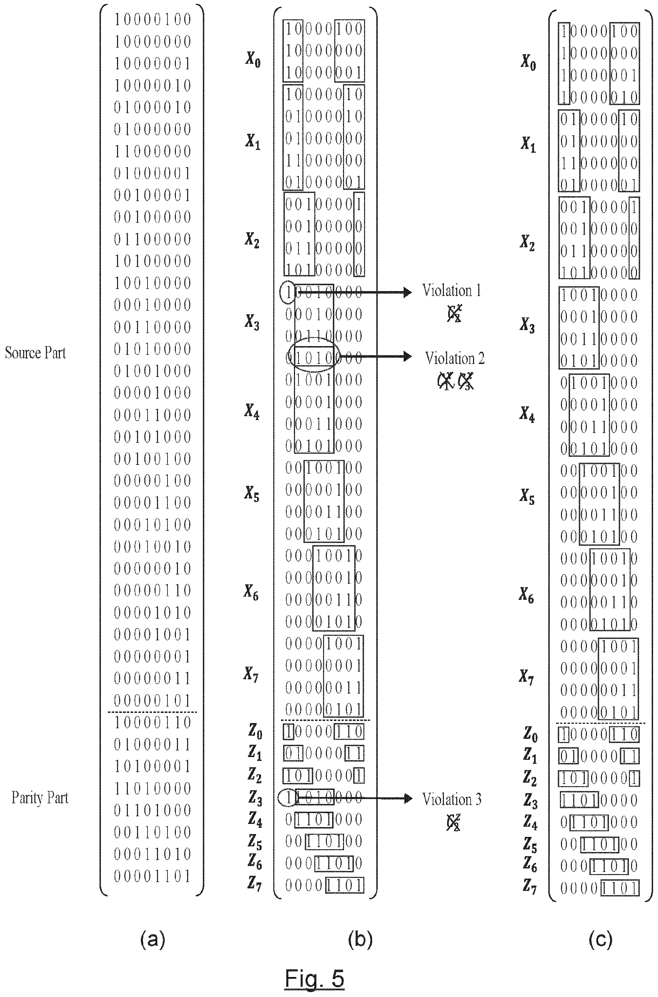

*1) An example of matrix decomposition:* Consider the binary RSC code of Figure 1 and assume a desired code rate *r =* 4/5, and an information block size of *K =* 32 bits with a regular parity transmission mask *m =* [0, 4, 8, 12, 16, 20, 24, 28], i.e., *M* = 8. The syndrome former matrix *S* to be decomposed is given in Figure 5a. To generate valid LTBs, the aforementioned constraints ( ${C}_{1}^{x} , {C}_{2}^{x} , {C}_{3}^{x} , {C}_{1}^{z} , {C}_{2}^{z}$) should be respected when decomposing the syndrome former matrix S. The decomposition is performed such that *N_{LTB} = M* = 8 LTBs *Tⱼ, j ∈*[0, 7], are obtained with their corresponding sub-blocks *Xⱼ* and *Zⱼ.* In Figure 5b, an invalid decomposition is illustrated, where some of the aforementioned constraints are not respected. A first violation is detected in sub-block *X*₃ of LTB *T*₃: constraint ${C}_{2}^{z}$ is not met: the first row of *X*₃ does not contain all non-zero elements of the corresponding row in *S.* The second violation appears at sub-block *X*₄, where the starting column position of sub-block position of sub-block *X*₄*, C*₄ = 1, and its predecessor sub-block *X*₃*, C*₃ = 1 violates condition ${C}_{3}^{x}$ in (25). Another violation appears in the same blocks due to the overlapping between sub-blocks *X*₃ and *X*₄: The accumulated height ${h}_{j}^{x}$ of all sub-blocks *Xⱼ* is equal to *K +* 1, hence, constraint ${C}_{1}^{z}$ is violated. Moreover, another violation appears in block *Z*₃ of the LTB *T*₃, where constraint ${C}_{2}^{z}$ is not respected.

On the other hand, Figure 5c shows a valid decomposition since all constraints, i.e. ( ${C}_{1}^{x} , {C}_{2}^{x} , {C}_{3}^{x} , {C}_{1}^{z} , {C}_{2}^{z}$) are met with no violation.

### B. MSCSF Processing

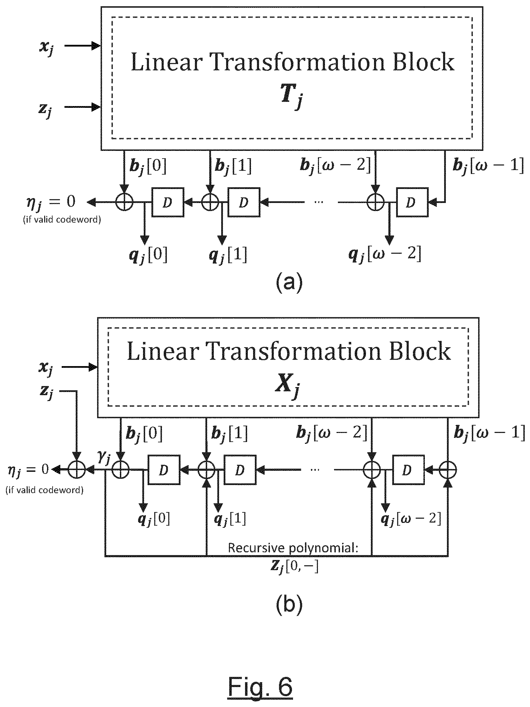

*1) Non-recursive structure (baseline):* The general structure of the non-recursive MSCSF is shown in Figure 6 a). At each time instance *j,* the MSCSF takes as inputs vectors *xⱼ* and *zⱼ* of size ${h}_{j}^{x}$ and ${h}_{j}^{z}$ respectively. These inputs are sequences extracted from the punctured codeword c = [*x, z*] such that ${x}_{j} \left[i\right] = x \left[i+{R}_{j}^{x}\right] , i ∈ \left〚0,{h}_{j}^{x}-1\right〛$ (28) ${z}_{j} \left[k\right] = z \left[x+{R}_{j}^{z}\right] , k ∈ \left〚0,{h}_{j}^{z}-1\right〛 .$ (29)

The MSCSF processes these inputs using the defined LTB of instance *j, Tⱼ*, to generate an output 1 × *ω* vector *bⱼ*: ${b}_{j} = \left[{x}_{j}, {z}_{j}\right] ⊗ {T}_{j}$ (30), with ⊗ being the symbols product as defined in Section 2-A.

The output *bⱼ* generated by LTB *Tⱼ* is used to update the contents of a size-(*v'*-1) register. The contents of the register, denoted by *qⱼ =* [*qⱼ*[0]*, ..., qⱼ*[*ω* - 2]] is first initialized (for a tail-biting code, the initial state is calculated in a preliminary pre-processing step, as described in Section 2.C) at *q*₋₁ *= qᵢₙᵢₜ* and is updated at each instance j ≥ 0 as follows: ${q}_{j + 1} \left[ω-2\right] = {b}_{j} \left[ω-1\right] ,$ (31) ${q}_{j + 1} \left[i\right] = {q}_{j} \left[i+1\right] ⊕ {b}_{j} \left[i+1\right] , i ∈ \left〚0,ω-3\right〛$ (32)

At each instance *j*, the MSCSF block generates an output syndrome symbol *ηⱼ*, computed as ${η}_{j} = {b}_{j} \left[0\right] ⊕ {q}_{j} \left[0\right]$ (33)

If *c̃* is valid codeword, the syndrome symbol *ηⱼ* should be 0 for all instance 0 ≤ *j* ≤ *N_{LTB} -* 1.

*2)Non-recursive structure (baseline):* Figure 6b) shows an alternative way to produce the same syndrome former using a recursive MSCSF structure. Such a structure exists if the height of all sub-blocks *Zⱼ* is equal to 1 ( ${h}_{j}^{z} = 1 , ∀ j$). In such a case, the sub-block *Xⱼ* is used as the LTB, which takes as input the source symbols *xⱼ* to generate an output 1 × *ω* vector *bⱼ*: ${b}_{j} = {x}_{j} ⊗ {X}_{j}$ (34)

The output *bⱼ* contributes to update the contents of a size(*ω* - 1) register *qⱼ* initialized at *qᵢₙᵢₜ.* In addition, a recursive symbol *γⱼ* is obtained through *γⱼ* = *bⱼ*[0] ⊕ *qⱼ*[0]*,* and contributes as well to update the content of the register. The recursive symbol *γⱼ* is multiplied (symbol product ⊗) by *Zⱼ*[0*,* i], then the result is summed symbol-wise (⊕ ) with the content of the (*i +* 1)^{th} register (*qⱼ*[*i*]) and the (*i +* 1)^{th} LTB output (*bⱼ*[*i*]). The contents of the registers are then updated accordingly to the following equations: ${q}_{j + 1} \left[ω-2\right] = {b}_{j} \left[ω-1\right] ⊕ \left({γ}_{j}⊗{Z}_{j}\left[0,ω-1\right]\right) ,$ (35) ${q}_{j + 1} \left[i\right] = {q}_{j} \left[i+1\right] ⊕ {b}_{j} \left[i+1\right] ⊕ \left({γ}_{j}⊗{Z}_{j}\left[0,i+1\right]\right) , i ∈ \left〚0,ω-3\right〛$ (36)

If *c̃* is a valid codeword, then the *(j* + 1)^{th} recursive symbol *γⱼ* is equal to the *(j* + 1)^{th} parity symbol *zⱼ*. The *(j* + 1)^{th} syndrome symbol is then obtained by summing these symbols: *ηⱼ = zⱼ* ⊕ *γⱼ.*

### C. Rate-r/(r + 1) Codes with Regular Puncturing

For rate *-r*/(*r +* 1) regularly punctured codes with *K* source symbols and *M* transmitted parity symbols, the decomposition of the corresponding syndrome former matrix *S* can be simplified. In this case, for each LTB *Tⱼ*:
- the starting column position *Cⱼ* is moved by 1 modulo *M* with respect to the starting column position of the previous LTB: *Cⱼ =* mod*_{M}*(*C*_{*j-*1} *+* 1),
- the height of sub-block *Zⱼ* is ${h}_{j}^{z} = 1$: the MSCSF only takes as input *zⱼ* one parity symbol at instance *j.* Thus, the MSCSF includes a total of *N_{LTB} = M* LTBs, the height of sub-block *Xⱼ* is ${h}_{j}^{x} = r$ if *j* > 0 and ${h}_{0}^{x} = {mod}_{r} \left(K\right)$ otherwise. This ensures that constraint ${C}_{1}^{x}$ is validated.

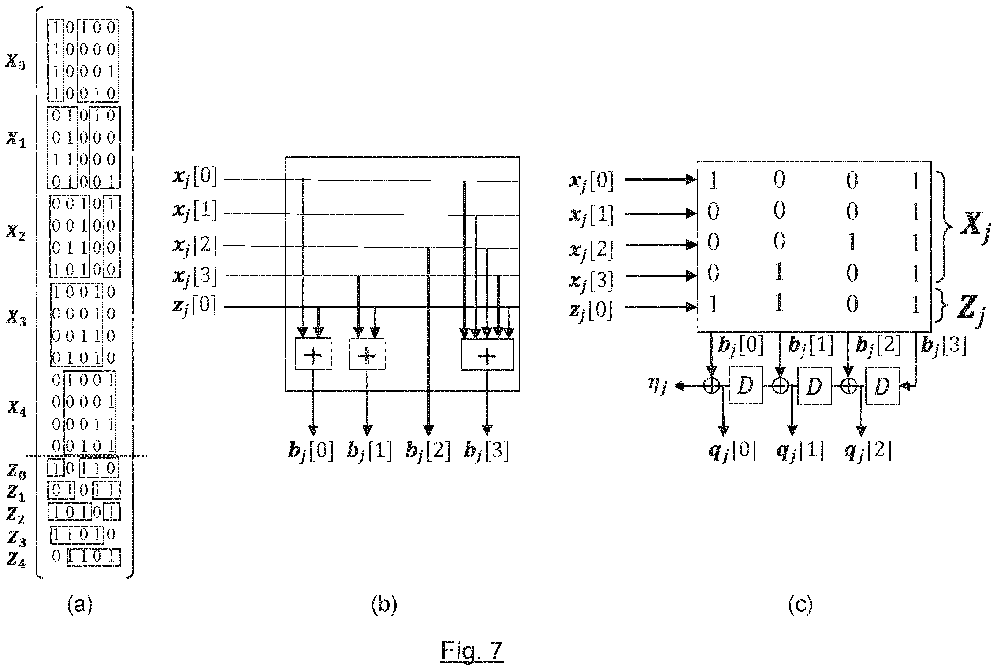

Consequently, in this particular case, the sub-block decomposition is tied to the choice of only 2 variables: the starting column position of the first *LTBs, C*₀*,* and the width of the sub-blocks, *ω*.
*1) An example of rate-r*/*(r + 1) code with regular puncturing:* The syndrome former matrix *S* of the RSC code of Figure 1, obtained for an information block size *K =* 20 bits, coding rate 4/5 achieved with the regular parity transmission mask *m =* [0, 4, 8, 12, 16], i.e., *M =* 5, is given in Figure 7a.

Since the parity transmission mask has a regular pattern, the syndrome former matrix *S* consists of *N_{LTB} = M =* 5 LTBs *Tⱼ*.

Since mod₄(20) = 0, the *M* LTBs all have the same height *h^{j}* = 5 with width *ω*= 4. The first LTB *T*₀ has a starting column at *C*₀ = 2 and, as aforementioned, each block*j* has a starting column that is shifted by one column with respect to its predecessor. Thus, the second LTB *T*₁ begins at *C*₁ = 3.

The inputs of the MSCSF at time instance *j* are *xⱼ =* [*xⱼ*[0]*, xⱼ*[1]*, xⱼ*[2]*, xⱼ*[3]] and z*ⱼ =* [*zⱼ*[0]] which are processed by the LTB *Tⱼ* as illustrated in Figure 7 to generate *bⱼ* such that ${b}_{j} \left[0\right] = {x}_{j} \left[0\right] ⊕ {z}_{j} \left[0\right] ,$ (37) ${b}_{j} \left[1\right] = {x}_{j} \left[3\right] ⊕ {z}_{j} \left[0\right] ,$ (38) ${b}_{j} \left[2\right] = {x}_{j} \left[2\right] ,$ (39) ${b}_{j} \left[3\right] = {x}_{j} \left[0\right] ⊕ {x}_{j} \left[1\right] ⊕ {x}_{j} \left[2\right] ⊕ {x}_{j} \left[3\right] ⊕ {z}_{j} \left[0\right] .$ (40)

As shown in Figure 7, the output *bⱼ* of LTB *Tⱼ* is fed into the length-(*ω* -1), i.e. length-3, register, whose contents is updated as follows: ${q}_{j + 1} \left[2\right] = {b}_{j} \left[3\right] ,$ (41) ${q}_{j + 1} \left[1\right] = {b}_{j} \left[2\right] ⊕ {q}_{j} \left[2\right] ,$ (42) ${q}_{j + 1} \left[0\right] = {b}_{j} \left[1\right] ⊕ {q}_{j} \left[1\right] .$ (43)

The output of the MSCSF, *ηⱼ* at instance *j* is computed as ${η}_{j} = {b}_{j} \left[0\right] ⊕ {q}_{j} \left[0\right] .$ (44)

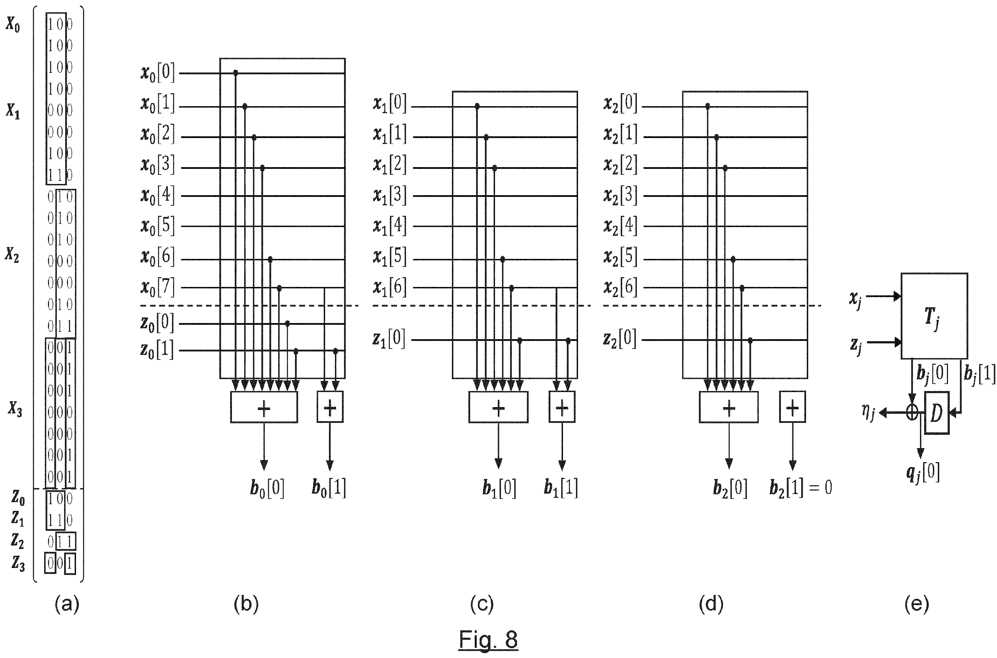

*2) An example of rate-p*/*(p + 1) code with regular puncturing, p being the code period:* This example is illustrated in Figure 8 for the same RSC code as in previous subsection. Its period is *p* = 7, the size of the considered information message is *K* = 22 and parity transmission mask is *m =* [0, 7, 14, 21] with *M =* 3. The corresponding syndrome former matrix *S* is provided in Figure 8a. According to the aforementioned criteria, syndrome former matrix *S* can be decomposed into *N_{LTB} = M-1* = 3 LTBs while respecting the decomposition constraints. The sub-blocks *X*₀ and *Z*₀ of first LTB *T*₀ have heights ${h}_{0}^{x} = 8$ and ${h}_{0}^{z} = 2$. The remaining blocks, $j ∈ \left〚1, 2\right〛$, all have the same height ${h}_{j}^{x} = 7$ and ${h}_{j}^{z} = 1$.

Figures 8b, 8c and 8d show the internal connections of the 3 LTBs (*T*₀*, T*₁*, T*₂)*.* Note that the output *b*₂[1] of the third LTB *T*₂ is always zero since all the elements in the second column of *T*₂ are equal to zero.

In this particular case of coding rate 7/8, where 7 is the code period, the length of the register is only *ω*-1 = 1, resulting in a 2-state MSCSF, as depicted in Figure 8e. This simplified structure makes decoding much less complex, as discussed in Section 7-C and 7-D.

### 6) STEP-4B: GRAPH-BASED REPRESENTATION

### A. General graph structure

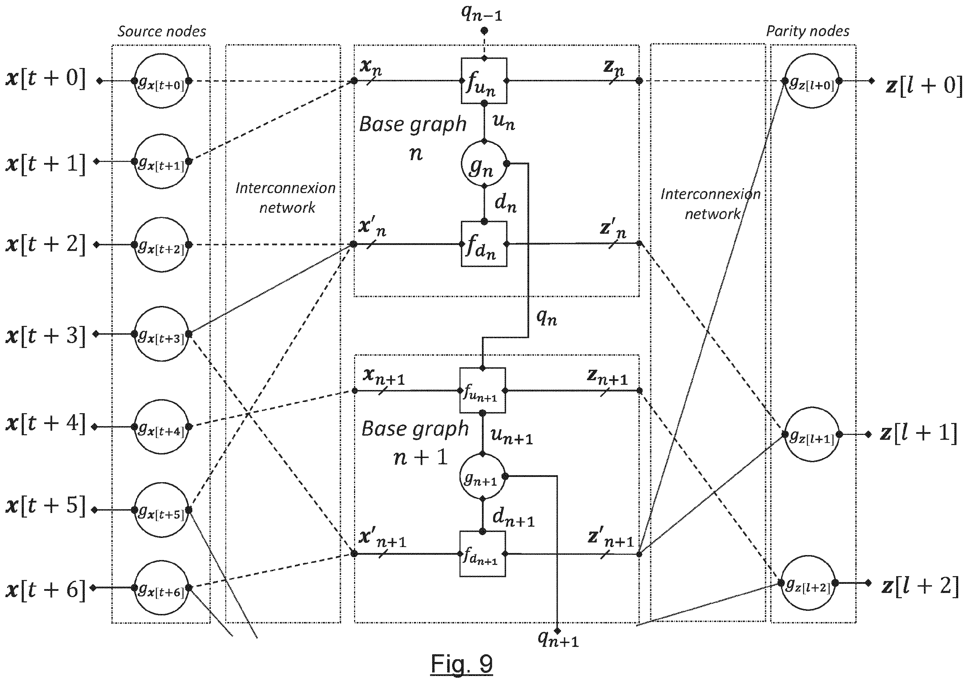

This section presents the general graph structure, shown in Figure 9, that captures the constraints between source and parity symbols of any punctured TB-RSC codes with base rate 1/2.

A graph is composed of nodes connected by edges. In Figure 9, the connection edges are fixed except the ones between pair of nodes that depend on the *N*_{*seq*_{⊥}} constrained dual codewords identified in step 3, which are represented by dashed lines.

Each edge (connection) between a pair of nodes carries a message that can be represented by either a scalar variable or a vector indicating, respectively, the symbol value (hard-decoding) or the reliability of symbol values (soft-decoding). In case of binary codes, the scalar variable can also represent the bit probability or LLR. Each node imposes constraints on every message entering that node. In the presented graph, there are two types of constraints represented by two types of nodes:
1) *f*-type nodes, represented by a square box in Figure 9, impose a parity constraint on the messages of all edges connected to that node. If *xᵢ,* $i ∈ \left〚0,L-1\right〛$ are messages from L connected edges, then ⊕*ᵢxᵢ* = 0. For instance, in Figure 9, the node *f_{uₙ}* is connected to 5 edges with messages *xₙ*[0]*, xₙ*[1]*, zₙ*[0], *uₙ* and *q*_{*n*-1} indicating that *xₙ*[0] ⊕ *xₙ*[1] ⊕ *zₙ*[0] ⊕ *uₙ* ⊕ *q*_{*n-*1} = 0. In the literature, this type of node is referred to as *factor nodes* or *check nodes.*
2) *g*-type nodes, represented by a circle in Figure 9, impose an equality constraint on the messages of all edges connected to that node: if *xᵢ, i E[0, L-1],* are messages from *L* connected edges, then *x*₀ = ··· *= xᵢ = ··· = x*_{*L-*1}*.* For instance, in Figure 9, the node *gₙ* is connected to 3 edges with messages *qₙ, uₙ* and *dₙ,* indicating that *qₙ* = *uₙ = dₙ.* In the literature, this type of node is referred to as *variable nodes.*

The overall graph structure can be decomposed into the following sub-graphs:
*1) The* "source nodes" *sub-graph:* composed of *K g*-type nodes *gₓ*. Each node *g*_{*x*[*t*]} is connected to the edge carrying source symbol *x*[*t*], and to one or multiple edges connected to either an *f_{uₙ}* or *f_{dₙ}* node in one or more base graphs - see subsection 3) below - through a first interconnection network. Note that there are some transmission masks where source symbols are not protected because they do not have any constraints with other symbols. In such cases, there are no edge connections with the base graphs.
*2) The* "parity nodes " *sub-graph:* composed of *N*_{*seq*_{⊥}} *g*-type nodes *g_{z}*. Each node *g*_{*z*[*l*]} is connected to the edge carrying the parity symbol *z*[*l*], and to one or multiple edges connected to either an *f_{uₙ}* or *f_{dₙ}* node in one or more base graphs - see subsection 3) below - through a second interconnection network.
*3) N*_{*seq*_{⊥}} "base graph" *sub-graphs:* each base graph *n, n ∈*[0, *N*_{*seq*_{⊥}} -1], is composed of two *f*-type nodes, named *f_{uₙ}* for the upper *f*-type node of the base graph and *f_{dₙ}* for the lower *f*-type node (see Figure 9). These two nodes are internally connected to a *g*-type node, *gₙ*, through edges carrying respectively *uₙ* and *dₙ* as messages. These messages are internal state symbol messages of the base graph. Note that these state symbols are not necessary equivalent to the state symbols of the MSCSF structure detailed in step-4A.

Both nodes (*f_{uₙ}, f_{dₙ}*) receive further edges from the two interconnection networks. For instance, in Figure 9, node *f_{dₙ}* is connected to nodes (g_{x[t+2]}, g_{x[t+3]}, g_{x[t+5]}) from the source nodes sub-graph, forming 3 edges with $x {′}_{n} = \left[{x}_{n}^{′}\left[0\right],{x}_{n}^{′}\left[1\right],{x}_{n}^{′}\left[2\right]\right]$ as messages. In addition, node *f_{dₙ}* is connected to node *g*_{*z*[*l+*1]} from the parity nodes sub-graph, forming an edge with ${z}_{n}^{′} = \left[{z}_{n}\left[0\right]\right]$ as messages.

The total number of edges (called node degree *N*_{deg}(.)) connected to node *f_{dₙ}* is therefore ${N}_{deg} \left({f}_{{d}_{n}}\right) = l \left({x}_{n}^{′}\right) + l \left({z}_{n}^{′}\right) + 1 = 5$ for the example presented in Figure 9. Similarly, we have *N*_{deg}(*f_{uₙ}*) *= ℓ*(*xₙ*) + *ℓ*(*zₙ*) + 2 = 5. These connections are dictated by the interconnection network and depend on the outcome of step 3. More information on the configuration of the interconnection network is given in the next section.

There is a last edge that directly connects node *gₙ* of base graph *n* to node *f*_{uₙ}+ 1 of base graph *n* + 1. This edge carries message *qₙ*, defined as the external state symbol message. This symbol is used to propagate a constraint from one base graph to another, making them dependent on each other.

### B. Interconnection networks construction

This section describes how to construct the two interconnection networks shown in Figure 9, based on the constrained dual codewords provided by step 3. As an initial configuration, we consider that both interconnection networks are empty, i.e. there is no edge connecting the *N*_{*seq*_{⊥}} base graphs to the source and parity symbols. Then, the connection edges are added step by step in each interconnection network, as described below.

To find the edge connections in the first interconnection network, we can define a *connection indicator table T^{x}*_{ind} as a *N*_{*seq*_{⊥}} ×*K* matrix where each element can only take 3 values:
- ${T}_{ind}^{x} \left[n, t\right] = 0 ⇒ node {g}_{x \left[t\right]}$ is not connected to base graph *n*.
- ${T}_{ind}^{x} \left[n, t\right] = 1 ⇒ node {g}_{x \left[t\right]}$ is connected to node *f_{uₙ}* in base graph *n*.
- ${T}_{ind}^{x} \left[n, t\right] = 2 ⇒ node {g}_{x \left[t\right]}$ is connected to node *f_{dₙ}* in base graph *n.*

For binary symbols, the table is then filled in as follows. It is first initialized with a row-wise concatenation of the dual parity bits y*ₙ*^{⊥} obtained in step 3: ${T}_{ind}^{x} = {\left[{y}^{⊥}\right]}_{n ∈ \left[0, {N}_{{seq}^{⊥}}-1\right]}$*.* Then, if there is a value 1 in two successive rows (*n, n +* 1) in a same column *t,* the value in row *n* is replaced by 2 and the value in row *n +* 1 is replaced by 0. This eliminates all girth-4 cycles between two successive base graphs *n* and *n +* 1, which is highly desirable if we want to apply an MPA-type decoding algorithm using the graph. One possible method to update the table accordingly is as follows. At each column *t*, the rows of table are successively updated from *n =* 0 to *n = N*_{*seq*_{⊥}} *-*1 by ${T}_{ind}^{x} \left[n, t\right] ← {T}_{ind}^{x} \left[n, t\right] + {mod}_{2} \left({T}_{ind}^{x}\left[n+1,t\right]\right) \times {T}_{ind}^{x} \left[n, t\right] ,$ ${T}_{ind}^{x} \left[n+1,t\right] ← {T}_{ind}^{x} \left[n+1,t\right] \times \left⌊{T}_{ind}^{x}\left[n, t\right]/2\right⌋ ,$

The construction of the second interconnection network follows the same logic. The connection indicator table is defined as *T*_{ind}^{z} as a *N*_{*seq*_{⊥}} ×*M* matrix where each elements can only takes 3 values:
- If ${T}_{ind}^{z} \left[n, l\right] = 0$: no edge is added to the graph.
- If ${T}_{ind}^{z} \left[n, l\right] = 1$: add an edge *g*_{*z*[*l*]} ↔ *f_{uₙ}.*
- If ${T}_{ind}^{z} \left[n, l\right] = 2$: add an edge *g*_{*z*[*l*]} ↔ *f_{dₙ}.*

The table is first initialized by a row-wise concatenation of the dual punctured source bits ${z}^{⊥} : {T}_{ind}^{z} = {\left[{z}^{⊥}\right]}_{n ∈ \left〚0,{N}_{{seq}^{⊥}}-1\right〛}$. Then, if there is a value 1 in two successive rows (*n, n* + 1) in a same column *l,* the 1 in row *n* is replaced by 2 and the 1 in row *n +* 1 is replaced by 0. One possible method to update the table accordingly is given by equation (41) where *T_{ind}^{x}* has to be replaced by *T*_{ind}*^{z}*.

Note that an extension to non-binary symbols is possible by applying suitable symbol-based *connection indicator tables* (*T*_{ind}*^{x}, T_{ind}^{z}*) where connection can take any value out of the symbol alphabet and by applying the same type of update procedure as the binary case.

### C. Simplified case for rate p/(p + 1)

We first show an example of the graph construction for a rate*-p*/(*p +* 1) code with *p* = 7, continuing the example of the *K* = 22, *N*_{*seq*_{⊥}} = 3 syndrome former matrix provided in Section 4.E. The constrained dual codewords are given by equations (16) (set of parity bits) and (17) (set of source bits), and the connection indicator tables based on these sequences are ${T}_{ind}^{x} = \left[\begin{matrix}1 , 1 , 1 , 1 , 0 , 0 , 1 , 2 , 0 , 0 , 0 , 0 , 0 , 0 , 0 , 0 , 0 , 0 , 0 , 0 , 0 , 0 \\ 0 , 0 , 0 , 0 , 0 , 0 , 0 , 0 , 1 , 1 , 1 , 0 , 0 , 1 , 2 , 0 , 0 , 0 , 0 , 0 , 0 , 0 \\ 0 , 0 , 0 , 0 , 0 , 0 , 0 , 0 , 0 , 0 , 0 , 0 , 0 , 0 , 0 , 1 , 1 , 1 , 0 , 0 , 1 , 1\end{matrix}\right]$ (45) and ${T}_{ind}^{z} = \left[\begin{matrix}1 , 2 , 0 , 0 \\ 0 , 0 , 2 , 0 \\ 0 , 0 , 0 , 1\end{matrix}\right]$ (46)

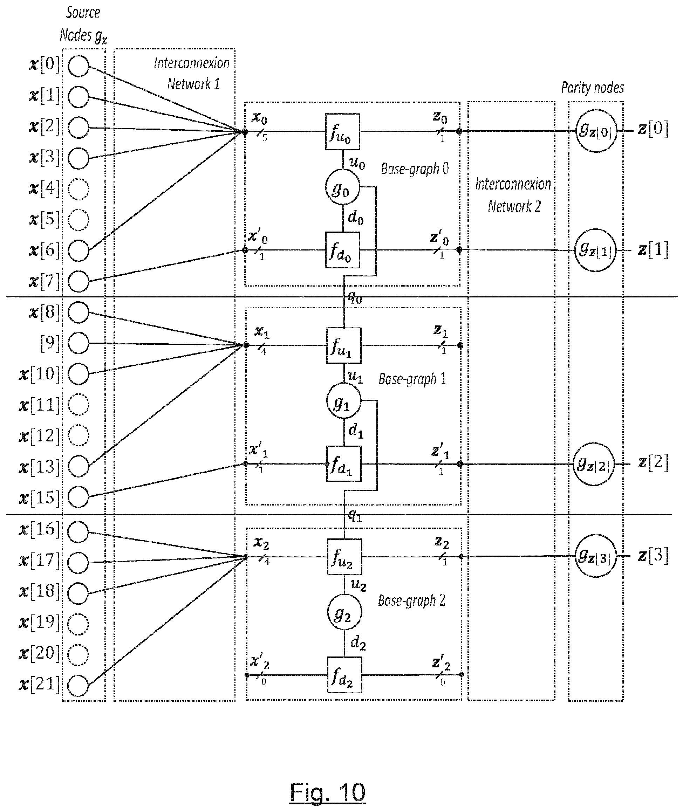

Following the edge filling rules described in the previous section, the graph presented in Figure 10 is obtained.

Since ${T}_{ind}^{x} \left[0, 0\right] = {T}_{ind}^{x} \left[0, 1\right] = {T}_{ind}^{x} \left[0, 2\right] = {T}_{ind}^{x} \left[0, 3\right] = {T}_{ind}^{x} \left[0, 6\right] = 1$, the nodes *g*_{*x*[0]}, *g*_{*x*[1]}*, g*_{*x*[*2*]}*, g*_{*x*[3]}*, g*_{*x*[6]} are connected to the upper *f*-type node, *f*_{*u*₀}, of the first base graph (indexed 0 in the figure). Node *g*_{*x*[7]} is connected to the down *f*-type node *f*_{*d*_{O}}, because ${T}_{ind}^{x} \left[0, 7\right] = 2$. The same logic applies for connecting the parity nodes: ${T}_{ind}^{z} \left[0, 0\right] = 1$ ⇒ *g*_{z[0]} ↔*f_{u_{O}}* and ${T}_{ind}^{z} \left[0, 1\right] = 2 ⇒ {g}_{z \left[1\right]} ↔ {f}_{{d}_{O}}$*.* The same process is repeated to connect the next base graphs.

For any *p*/(*p* +1) TB-RSC encoder with a regular transmission mask, the connection indicator tables can be written in the form described in equations (47) for ${T}_{ind}^{x}$ and (48) for ${T}_{ind}^{z}$. Consequently, the first interconnection network (connections to source nodes) can be directly configured by adding the following edges:
- $\begin{matrix}{g}_{x \left[0\right]} ↔ {f}_{{u}_{0}} and {g}_{x \left[k+np\right]} ↔ {f}_{{u}_{n}} if {y}_{0}^{⊥} \left[k\right] = 1 , n ∈ \\ \left〚0,M-2\right〛 , k ∈ \left〚1,p-1\right〛 ,\end{matrix}$
-
${g}_{x \left[\left(n+1\right)p\right]} ↔ {f}_{{d}_{n}} , n ∈ \left〚0, M-3\right〛 ,$

An example of such a graph is given in Figure 10. $\begin{matrix}{T}_{ind}^{x} = \left[\begin{matrix}… & … & … & … & … & … & … & … & … & … & … & … & … & … & … & … \\ … & 0 & {y}_{0}^{⊥} \left[1\right] & … & {y}_{0}^{⊥} \left[p-1\right] & 2 & 0 & … & … & … & … & … & … & … & … & … \\ … & … & … & … & … & 0 & {y}_{0}^{⊥} \left[1\right] & … & {y}_{0}^{⊥} \left[p-1\right] & 2 & 0 & … & … & … & … & … \\ … & … & … & … & … & … & … & … & … & 0 & {y}_{0}^{⊥} \left[1\right] & … & {y}_{0}^{⊥} \left[p-1\right] & 2 & 0 & … \\ … & … & … & … & … & … & … & … & … & … & … & … & … & … & … & …\end{matrix}\right] , \\ {T}_{ind}^{x} \left[0,-\right] = \left[1 {y}_{0}^{⊥}\left[1\right] … {y}_{0}^{⊥}\left[p-1\right] 2 0 …\right] , \\ {T}_{ind}^{x} \left[M-2,-\right] = \left[… 0 {y}_{0}^{⊥}\left[1\right] … {y}_{0}^{⊥}\left[p-1\right]\right] ,\end{matrix}$ (47) ${T}_{ind}^{z} = \left[\begin{matrix}1 & 2 & 0 & … & … & … & … & … \\ 0 & 0 & 2 & 0 & … & … & … & … \\ … & … & 0 & 2 & 0 & … & … & … \\ … & … & … & 0 & 2 & 0 & … & … \\ ⋮ & ⋮ & ⋮ & ⋮ & ⋮ & ⋮ & ⋮ & ⋮ \\ … & … & … & … & … & 0 & 2 & 0 \\ … & … & … & … & … & 0 & 0 & 1\end{matrix}\right]$ (48)

### D. Decoding on the graph structure

Graph-based decoding is well-known in the literature and all of them are variants of MPA. Below is a list of MPA algorithms for binary codes:
1) Algorithms where exchanged messages are symbol values: Gallager A and B algorithms [10]. These algorithms are suitable for binary symmetric channels or applications requiring very low computational complexity or energy.
2) Algorithms where exchanged messages are probability of bits being 0 or 1 (soft values): sum-product algorithm (SPA) [11], [12], also known as belief propagation (BP). These algorithms are suitable when a reliability measure is available for the received bits. Can be used for simulations (computer programs) or theoretical analysis.
3) Algorithms where exchanged messages are log-likehood ratio (LLR) of bits (soft values): log-SPA [13], Min-sum (MS) [14] and their variants with different scaling factors. There are all considered as a sub-class of BP algorithms. These algorithms are suitable for hardware implementation.

Most of these MPA algorithms can be extended to the case of non-binary codes [16]. All the above classes of algorithms can be applied on the graph structure for decoding the received codeword. MPA is known to provide exact MAP inference if the graph is cycle-free, which is the case for the graph obtained with rate-*p*/(*p* + 1) TB-RSC encoders with a regular transmission mask. The graph decomposition is very appealing in this case where the computational complexity can be significantly reduced with respect to MAP approaches using the code trellis.

### 7) EXAMPLES OF APPLICATION AND RESULTS

The proposed simplified MSCSF or graph structures can be used for lowering the decoding complexity of RSC codes and their concatenation. In Section 7.A, a decomposition of a low-rate RSC into multiple higher-rate RSCs is presented. Then, the embedding of the decomposed RSC within a turbo code is presented in Section 7-B. Next, we present a computational complexity analysis of the decoding process for a rate *r* = 7/8 with a regular parity transmission mask *m* = [0, 7, 14, ···] using the MAP and MPA decoding approaches in Section 7.C and Section 7.D respectively.

### A. Decomposition of a low-rate RSC into multiple higher-rate RSCs

A way to achieve a rate-*r'* RSC is to decompose it into multiple higher rate-*r* RSCs with *r > r'.* One possibility is to decompose a RSC with rate *r' = k*/(*k + m*) into *m* RSCs of rate *r = k*/(*k +* 1), whose decoders iteratively exchange extrinsic information on source symbols x.

As an example, let the desired rate be *r'* = 7/9 and an information block of size *K =* 57, with a regular parity transmission masks *m* = [0, 3, 7, 10, 14, 17, 21, 24, 28, 31, 35, 38, 42, 45, 49, 52, 56].

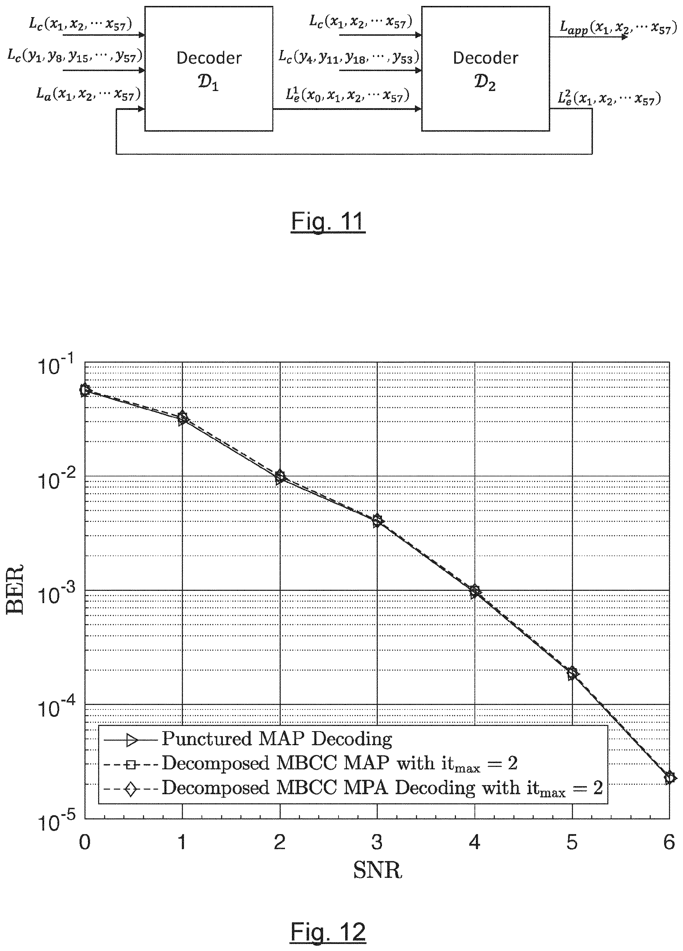

The parity mask *m* can be split into two sub-masks *m*₁ = [0, 7, 14, 21, 28, 35, 42, 49, 56] and *m*₂ = [3, 10, 17, 24, 31, 38, 45, 52] to generate two rate-7/8 RSCs. Both RSCs are decoded using the MAP or MPA decoding algorithm and exchange extrinsic information on the source bits. As shown in Figure 11, the decoders of the first RSC decoder, *D*₁, and the second RSC decoder, *D*₂, consider the same channel observation on the source symbols, denoted by *L_{c}*(*x*₀*,* ···, *x*₅₆). Each decoder *Dᵢ* considers the channel observation of the non-punctured parity symbols based on the corresponding mask *mᵢ,* i.e., *L_{c}*(*y*₀*, y*₆*,* , *y*₅₆) and *L_{c}*(*y*₃*,* y₁₀*,* ···, y₅₂) respectively. The generated extrinsic information *L*ₑ¹ and *L*ₑ² from the first and second decoder respectively are exchanged iteratively such that the *a priori* information of the decoder is updated with the extrinsic information provided by the other decoder until reaching the predefined maximum number of iterations itₘₐₓ.

The bit-error rate (BER) performance presented in Figure 12 illustrates the simulation results of the decoding performance of the rate-7/9 decomposed binary RSC code with masks *m*₁ and *m*₂, as well as the overall punctured convolutional code with mask *m.* These simulations are performed using the max-log-MAP (MLM) approximation for MAP decoding. The simulation considers binary phase-shift keying (BPSK) modulation, additive white Gaussian noise (AWGN) channel, and a maximum number of iterations equal to itₘₐₓ = 2.

The three curves merge. For a cycle-free PCM, the *a posteriori* inferences generated using the MPA decoding or the MAP decoding are identical. Hence, since the PCM of the rate-7/8 RSC code is cycle free, the MPA-based and the MAP-based decoding of the RSC code have identical inference, i.e., identical performance. Moreover, decomposing the rate-7/9 RSC decoder into two rate-7/8 RSC decoders to decode with two decoders exchanging extrinsic information does not affect its error correction performance.

### B. Turbo decoding using decomposed convolutional codes

Turbo codes consists of the parallel concatenation of multiple (usually two) constituent convolutional codes which are separated by interleavers. Embedding the decomposed RSC as constituent codes within a turbo code allows for significant reduction in the decoding complexity of the turbo decoder.

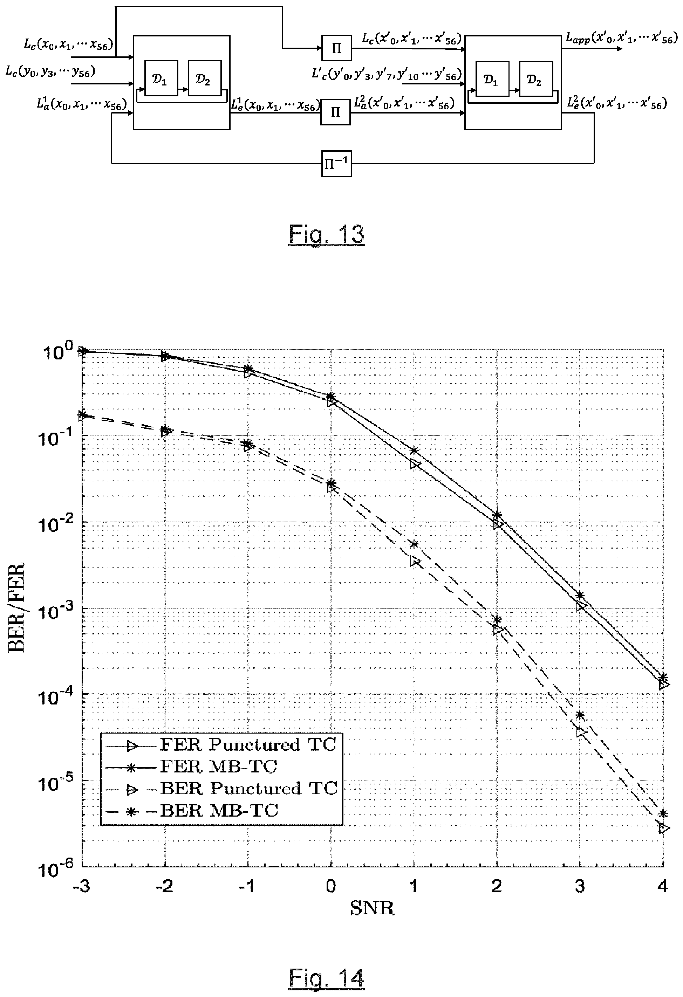

As an example, the concatenation of two decomposed RSC decoders of rate *r'* = 7/9 separated by an interleaver yields a turbo decoder with a coding rate *r* = 7/11. As shown in Figure 13, the turbo decoder exchanges extrinsic information iteratively between the two constituent decoders until reaching a maximum number of iterations it_{maxTurbo}. Internally, each constituent code includes two decomposed RSC decoders which exchange extrinsic information with each other before generating the extrinsic information of the main constituent decoder.

The BER and frame error rate (FER) of a conventional punctured binary turbo decoder and the proposed turbo decoder described in Figure 13 are reported in Figure 14, for *K* = 57 and *r* = 7/11 using the MLM approximation for MAP decoding and a maximum number of turbo iterations it_{maxTurbo} = 8. The interleaver Π adopted in the simulation is an almost regular permutation (ARP) interleaver with parameters *P* = 50, *Q* = 3, *S* = [1, 40, 13]: $Π \left(i\right) = {mod}_{K} P ⋅ i + S \left[{mod}_{O}\left(i\right)\right] .$ (47)

The simulation considers BPSK modulated symbols that are transmitted through an AWGN channel. The decomposed RSC decoders of each constituent decoder iterate only twice for exchanging extrinsic information internally. As shown in the figure, there is a minor degradation of less than 0.2 dB in terms of BER and less than 0.1 dB in terms of FER, compared to a conventional turbo decoder. However, this minor degradation provides a considerable complexity reduction as explained in the following section.

### C. Complexity analysis of MAP-based decoding of RSC codes

The complexity of a MAP decoder is based on the trellis of the code. Since the trellis of the MSCSF with rate 7/8 is a two-state trellis, the complexity is lower than that of the 8-state punctured code.

The complexity analysis compares the MSCSF MLM-based MAP decoder with the conventional radix-2⁷ MLM-based MAP decoder and the radix-2 MLM-based MAP decoder, all using the local-soft output Viterbi algorithm (L- SOVA) [15]. Per each trellis stage, the radix-2⁷ MAP decoder requires 506 addition and 297 comparison operations to generate the *a posteriori* LLRs of the 7 source bits. For the radix-2 MAP, only one a posteriori information is generated per decoding stage. Therefore, to compare with radix-2⁷, the complexity figures of 7 trellis stages are accumulated. For 7 decoding stages of a radix-2 MAP decoder, the number of addition and comparison operations is 504 additions and 368 comparisons. On the other hand, the two-state MSCSF MAP decoder requires 272 additions and 50 comparison operations to generate the *a posteriori* LLRs of the 7 source bits. As a result, the complexity of MSCSF MAP decoding is less than the complexity of the conventional radix-2⁷ MAP decoder by 47% in terms of addition operations and by 83% in terms of comparison operations. Moreover, the complexity of the MSCSF MAP decoder is less than the radix-2 MAP decoder by 50% and by 86% in terms of addition and comparison operations.

### D. Complexity analysis of MPA-based decoding using the graph

For the rate-7/8 binary RSC code, the graph representation of the MPA algorithm is as illustrated in Figure 10. Each base graph generates an inference on 7 source bits, therefore, the complexity of each base graph is comparable to that of each trellis stage of the MAP decoder.

For an MS-based MPA decoding, a base-graph requires a total of 8 additions and 12 comparisons. Therefore, the hardware requirements to perform one base-graph operation is significantly lower than the requirements to perform one trellis decoding stage in the MAP-based decoders. To sum up, the complexity of the MAP-based decoders and the MPA-based decoder is summarized in Table I.

**TABLE I**

| COMPLEXITY COMPARISON PER DECODING STAGE FOR RATE 7/8 | | |
|---|---|---|
| Decoding Scheme | Additions | Comparisons |
| Radix-2 Punctured CC MAP (7 trellis steps) | 504 | 368 |
| Radix-2⁷ Punctured CC MAP | 506 | 297 |
| Radix-2⁷ MBCC MAP | 272 | 50 |
| Graph-based MPA decoding | 8 | 12 |

### E. conclusion

The invention is built on the basis of a new approach of the parity relations that links the source and parity symbols of a data sub-block of size *m* and the symbols of neighboring sub-blocks.

This approach leads to a new building of the code as a multi-symbol convolutional syndrome former with a number *ω* - 1 of memory elements, which can be represented by a trellis with 2^{*ω*-1} states.

The invention is particularly adapted for applications requiring high data throughput. In the current state of the art, increasing data throughput is achieved at the cost of increasing circuit consumption (consumption increases linearly with throughput).

The invention drastically reduces complexity and power consumption of the decoding process.

### APPENDIX A

### Method for finding the constrained dual RTZ sequences in step 2 of the invention.

There are several possible methods to find the RTZ sequences *xₙ*^{⊥} that satisfy constraints (*C*₁, *C₂, C*₃) in step 2 (Section 4.C). An example of such a method is to enumerate all combinations of sequences and test if they verify the said constraints. To limit the search space to a tractable level for computer programs, the number combination can be restricted to sequences of length up to *L_{RTZ},* with *L_{RTZ}* ≤*M* being inferior or equal to the number of transmitted parity symbols. For instance, considering binary symbols, the list of all odd-valued integers *uₖ* from 1 to *2^{L^{RTZ}}* -1 can be enumerated: *uₖ = 2k -*1*, k ∈*[1*,* 2^{*L*L*^{RTZ}*-1}]*.*

Then, each *uₖ* value can be converted into a binary sequence of *M* bits *uₖ* = [mod₂(*uₖ*/*2^{b}*)]_{*b∈*[0,*M-*1]}, the least significant bit being placed at the first position and is always equals to 1 by construction: *u*[0] = 1, Vk *∈*[1,2*^{LRTZ}*-1]*.* Thus, constraint *C*₃ can be directly satisfied.

For each combination *k,* the *M* elements (bits) of *uₖ* are mapped to *M* non-zero positions in a sequence of *K* bits *vₖ* such as ${↺}_{- {r}_{n}} {υ}_{k}$ satisfies constraint *C*₁. This is done as follows. The length-K sequence *vₖ* is first initialized at 0: *vₖ* = [0, ... , 0]. Then, an indexing vector *δₙ* is defined as length-*M* vector where each element indicates a non-zero position in *vₖ* such as ${↺}_{- {r}_{n}} {υ}_{k}$ satisfies constraint C₁. This indexing vector is equals to ${δ}_{n} = {↺}_{{r}_{n}} \left(m-m\left.\left[n\right]\right|\right) .$ (48)

Note that the above equation ensure that all modular positions are sorted in ascending order: ${mod}_{M} \left({δ}_{n}\left[t\right]\right) < {mod}_{M} \left({δ}_{n}\left[t+1\right]\right) , ∀ t ∈ \left〚0,M-1\right〛$ (49)

Furthermore, *δₙ*[0] = 1 to ensure *uₖ*[0] is mapped to *uₖ*[0] *=* 1, implying that *C*₃ is verified. Finally, the element at position *δₙ*[*t*] in *vₖ* is assigned to the *t*^{th} bit of *uₖ* from *t =* 0 to *t = M -*1: ${υ}_{k} \left[{δ}_{n}\left[t\right]\right] ← {u}_{k} \left[t\right] , ∀ t ∈ \left〚0, \left|M-1\right.\right〛 .$ (50)

The list of solutions is then given by ${U}_{n} = \left\{{↺}_{- {r}_{n}}{υ}_{k}:{υ}_{k} satisfy {C}_{2}\right\}$ (51)

From here, different selection criteria (*S*₁, *S₂,* S₃) can be applied to reduce the list to a unique solution, as described in Section 4.C.

### APPENDIX B - REFERENCES

[1] H. Ma and J. Wolf, "On tailbiting convolutional codes," IEEE Transactions on Communications, vol. 34, no. 2, pp. 104-111, 1986.
[2] C. Weiss, C. Bettstetter, S. Riedel, and D. Costello, "Turbo decoding with tail-biting trellises," in 1998 URSI International Symposium on Signals, Systems, and Electronics. Conference Proceedings (Cat. No.98EX167), 1998, pp. 343-348.
[3] G. Forney, "The Viterbi algorithm," Proc. of IEEE, vol. 61, no. 3, pp. 268-278, 1973.
[4] --, "Convolutional codes II: Maximum-likelihood decoding," Inf. Control, vol. 25, pp. 222-250, 1974.
[5] L. Bahl, J. Cocke, F. Jelinek, and J. Raviv, "Optimal decoding of linear codes for minimizing symbol error rate (corresp.)," IEEE Trans. on Inf. Theory.
[6] G. Battail, "Pondération des symboles décodés par l'algorithme de Viterbi," Ann. Telecomm., vol. 42, no. 1-2, pp. 31-38, 1987.
[7] J. Hagenauer and P. Hoeher, "A Viterbi algorithm with soft-decision outputs and its applications," in Proc. of 1989 IEEE Global Telecommunications Conference and Exhibition "Communications Technology for the 1990s and Beyond', Dallas, TX, USA, vol. 3, Nov. 1989, pp. 47.1.1-47.1.7.
[8] P. Robertson, E. Villebrun, and P. Hoeher, "A comparison of optimal and sub-optimal decoding algorithms in the log domain," in IEEE International Conference on Communications, Seattle, WA, USA, Jun. 1995, p. 1009-1013.
[9] A. Refaey, S. Roy, and P. Fortier, "On the application of bp decoding to convolutional and turbo codes," in 2009 Conference Record of the Forty-Third Asilomar Conference on Signals, Systems and Computers, 2009, pp. 996-1001.
[10] R. Gallager, "Low-density parity-check codes," IRE Transactions on Information Theory, vol. 8, no. 1, pp. 21-28, 1962.
[11] D. MacKay, "Good error-correcting codes based on very sparse matrices," IEEE Transactions on Information Theory, vol. 45, no. 2, pp. 399-431, 1999.
[12] F. Kschischang, B. Frey, and H.-A. Loeliger, "Factor graphs and the sum-product algorithm," IEEE Transactions on Information Theory, vol. 47, no. 2, pp. 498-519, 2001.
[13] X.-Y. Hu, E. Eleftheriou, D.-M. Arnold, and A. Dholakia, "Efficient implementations of the sum-product algorithm for decoding LDPC codes," in GLOBECOM'01. IEEE Global Telecommunications Conference (Cat. No.01CH37270), vol. 2, 2001, pp. 1036-1036E vol.2.
[14] M. Fossorier, M. Mihaljevic, and H. Imai, "Reduced complexity iterative decoding of low-density parity check codes based on belief propagation," IEEE Transactions on Communications, vol. 47, no. 5, pp. 673-680, 1999.
[15] V. H. S. Le, C. Abdel Nour, E. Boutillon, and C. Douillard, "Revisiting the Max-Log-Map algorithm with SOVA update rules: new simplifications for high-radix SISO decoders," IEEE Trans. Commun., vol. 68, no. 4, pp. 1991-2004, 202.
[16] O. Ferraz et al., "A Survey on High-Throughput Non-Binary LDPC Decoders: ASIC, FPGA, and GPU Architectures," in IEEE Communications Surveys & Tutorials, vol. 24, no. 1, pp. 524-556, 2022.

## Claims

1. Method for decoding received codewords *c* generated by a transmission encoder using a recursive convolutional code with puncturing, said codewords c comprising a set of *K* source symbols and a set of *M* parity symbols,
wherein said method decodes said received codewords using a syndrome former matrix ***S*** with *K + M* rows and *N*_{*seq*_{⊥}} columns, *M-1 ≤ N*_{*seq*_{⊥}} *≤ M,* or a corresponding transposed syndrome former matrix ***S***^{†},
said syndrome former matrix columns being composed of a set of *N*_{*seq*_{⊥}} constrained dual codewords obtained from a predetermined dual encoder of said transmission encoder, said *N*_{*seq*_{⊥}} columns being linearly independent,
the columns and the rows being exchanged where the transposed syndrome former matrix ***S***^{†} is used,
each constrained dual codeword comprising a set of *M* dual source symbols and a set of *K* dual parity symbols, organized so as said constrained dual codeword comprises a single non-zero sub-codeword, comprising a dual source symbol part, respectively a dual parity symbol part, starting with a first non-zero symbol and terminating with a last non-zero symbol, of length independent of *K,* all other symbols of the dual codeword being zero symbols, the number of non-zero elements in said matrix being kept as low as possible,
at least the last non-zero element in a given column being followed, on the line carrying said last non-zero element and in the next column, by a non-zero element,
and wherein said decoding comprises a computation of *N*_{*seq*_{⊥}} syndrome symbols, said computation being applied locally on the non-zero sub-codeword of each constrained dual codeword.

2. Method according to claim 1, comprising following steps for a conversion of said recursive convolutional code into a syndrome former:
- step 1: building said predetermined dual encoder of said transmission encoder, without considering said puncturing, by selecting, among several available dual encoders, the predetermined dual encoder fulfilling following conditions:
- the predetermined dual encoder is directly derived from the encoding structure of the original transmission encoder;
- the positions of the *K* dual source symbols ***x***_{⊥} in the dual codewords *c*_{⊥} of the corresponding predetermined dual encoder are aligned with the positions of the *K* parity symbols ***y*** in the original codeword *c* of said transmission encoder before puncturing;
- step 2: identifying said set *N*_{*seq*_{⊥}} constrained dual sequences, under the form of a list of *N*_{*seq*_{⊥}} constrained return-to-state-zero, or RTZ, sequences under following constraints:
- encoding said sequence with said predetermined dual encoder produces a dual codeword comprising a single non-zero sub-codeword;
- symbols of said sequence at punctured positions of said puncturing are set to zero;
- step 3: encoding then puncturing dual source symbols of said *N*_{*seq*_{⊥}} constrained RTZ sequences using said predetermined dual encoder, providing *N*_{*seq*_{⊥}} constrained dual codewords, each comprising a set of *M* dual source symbols and a set of *K* dual parity symbols;
- step 4: combining said *N*_{*seq*_{⊥}} constrained dual codewords to form said syndrome former matrix ***S*** having *N*_{*seq*_{⊥}} columns, each column corresponding to one of said constrained dual codewords.

3. Method according to claim 2, wherein said step 4 is a step of:
- step 4A: constructing a multi-symbol convolutional syndrome former structure based on a decomposition of said syndrome former matrix ***S*** into at most *M* submatrices, called linear transformation blocks, or LTBs, ***T**ⱼ*.

4. Method according to claim 2, wherein said step 4 is a step of:
- step 4B: constructing a graph structure based on said syndrome former matrix ***S**.*

5. Method according to any of claims 2 to 4, further comprising a step 5 of decoding said received codewords considering the syndrome former constructed in step 4.

6. Method according to claim 5, wherein said step 5 of decoding uses at least one of the decoding algorithms belonging to the group comprising:
- Message Passing Algorithm (MPA);
- Maximum A Posteriori Probability algorithm (MAP);
- Viterbi Algorithm (VA).

7. Method according to any of claims 2 to 6, wherein the dual source symbol part of the *n*^{th} constrained dual codeword starts at a position corresponding to the position of the *n*^{th} transmitted parity symbol in the transmission encoder.

8. Method according to claim 7, wherein said *N*_{*seq*_{⊥}} constrained dual RTZ sequences, or said *N*_{*seq*_{⊥}} constrained dual RTZ codewords, are selected using selection criteria aiming to find an equivalent syndrome former for said dual encoder suitable for low-complexity decoding.

9. Method according to any of claims 1 to 8, wherein said transmission code has a coding rate *r*/(*r +* 1).

10. Method according to claims 7 and 9, wherein r is equal to the convolution period *p* of said predetermined dual encoder, and wherein the first constrained dual RTZ sequence is composed of only two non-zero symbols, separated in position by *p* - 1 symbols at 0.

11. Method according to claims 7 and 9, wherein Step 2 comprises the steps of:
- identifying a first constrained dual RTZ sequence ***x*₀**^{⊥};
- obtaining the *N*_{*seq*_{⊥}} *-* 1 remaining constrained dual RTZ sequence with a righthand rotation of ***x***₀^{⊥} by ${x}_{n}^{⊥} = {↺}_{- nr} {x}_{0}^{⊥}$, multiples of *r*: $n ∈ \left〚0,{N}_{{seq}^{⊥}}-1\right〛$.

12. Method according to claim 3, wherein Step 4A comprises the following step:
- decomposing said syndrome former matrix ***S*** in at most *M* linear transformation blocks ***T**ⱼ*, *j* ≤*M,* each linear transformation blocks ***T**ⱼ* being decomposed into two sub-blocks (***X**ⱼ, **Z**ⱼ*), where ***X**ⱼ* and ***Z**ⱼ* matrices are sub-blocks extracted from matrix ***S*,**
***X**ⱼ* corresponding to an extraction performed on *hⱼ^{x}* successive rows among the first *K* rows in ***S*** and *ω* successive columns and ***Z**ⱼ*, corresponding to an extraction is performed on *hⱼ^{z}* successive rows among the last *M* rows in ***S*** and *ω* successive columns,
and wherein all sub-blocks ***X**ⱼ* and ***Z**ⱼ* satisfy the following set of constraints:
- each row of the syndrome former matrix ***S*** must be assigned to exactly one sub-block;
- the linear transformation blocks contain all non-zero elements of the syndrome former matrix ***S***;
- the starting column position of the *j*^{th} linear transformation block is circularly anterior to the starting column position of the (*j* + 1)^{th} linear transformation blocks.

13. Method according to claim 12, wherein the multi-symbol convolutional syndrome former takes as inputs, at each time instance *j,* inputs *hⱼ^{x}* source symbols ***x**ⱼ* and *hⱼ^{z}* parity symbols ***z**ⱼ* extracted from the transmitted codewords c and processes these inputs using the linear transformation blocks ***T**ⱼ*, providing an output ***b**ⱼ:* ${b}_{j} = \left[{x}_{j}, {z}_{j}\right] \times {T}_{j}$ said output ***b**ⱼ* updating the contents of a size-(*ω* - 1) register ***q**ⱼ =* [***q**ⱼ*[0], *... , **q**ⱼ*[*ω* - 2]] so that, at each instance *j*, the multi-symbol convolutional syndrome former generates an output syndrome symbol *ηⱼ*, computed as ${η}_{j} = {b}_{j} \left[0\right] ⊕ {q}_{j} \left[0\right]$

14. Method according to claims 9 and 12, wherein in Step 2:
- *ω* -1 is equal to the positional distance between the first and the last non-zero symbols in the dual source symbol part in the first constrained dual codeword;
- *hⱼ^{z}* is equal to 1;
- *hⱼ^{x}* is equal to *r*;
- all the linear transform blocks ***T**ⱼ* have the same content ***T**.*

15. Method according to claim 14, wherein r is equal to the convolution period of the dual encoder *p* and *ω* is equal to 2.

16. Method according to claim 4, wherein Step 4B comprises constructing a general decoding graph structure, composed of nodes connected by edges, each node imposing constraints on every message entering that node, the decoding graph structure comprising:
- a source nodes sub-graph composed of *K g*-type nodes *gₓ*;
- a parity nodes sub-graph composed of *M g*-type nodes *g_{z}*;
- *N*_{*seq*_{⊥}} base graph sub-graphs, each base graph *n, n ∈*[0, *N*_{*seq*_{⊥}} *-*1]*,* being composed of two *f-*type nodes, named *f_{uₙ}* for the upper *f*-type node of the base graph and *f_{dₙ}* for the lower *f-*type node,
wherein a *f*-type node imposes a parity constraint on the messages of all edges connected to that node and a *g*-type node imposes an equality constraint on a message of all edges connected to that node,
and two interconnection networks based on said encoded constrained dual codewords provided by Step 3, interconnecting respectively said source nodes sub-graph with said *N*_{*seq*_{⊥}} base graph sub-graphs and said *N*_{*seq*_{⊥}} base graph sub-graphs with said parity nodes sub-graph.

17. Method according to any of the claims 1 to 16, wherein the transmission encoder uses a concatenation of at least two recursive convolutional codes, each recursive convolutional code being previously turned into a multi-symbol convolutional syndrome former.

18. Method for decoding received codewords c , said codewords c being generated by a transmission encoder composed of multiple recursive convolutional codes with different puncturing, each encoding the same *K* source symbols, wherein the method comprises a multiple multi-symbol convolutional syndrome former, each implementing the method according to any of the claims 1 to 17, and exchanging information on syndrome symbols.

19. Decoder of codewords *c* generated by a transmission encoder using a recursive convolutional code with puncturing, said codewords c comprising *K* source symbols and *M* parity symbols, comprising decoding means of a multi-symbol convolutional syndrome former, implementing the method according to any of the claims 1 to 18.

20. Computer program product comprising instructions for implementing the method according to one of claims 1 to 18 when this program is executed by a processor.
